# FASCICULE DE BREVET EUROPEEN

(11) **EP 3 843 294 B1**
(45) Date de publication et mention de la délivrance du brevet: **14.09.2022**
(21) Numéro de dépôt: 20215889.5
(22) Date de dépôt: 21.12.2020
(51) Int. Cl.: H04B 10/70, H01L 33/06, H01L 33/18, H01L 33/20, B82Y 20/00, H01L 33/00, H01L 33/30, H01L 33/44

(54) **SOURCE DE LUMIÈRE ADAPTÉE À ÉMETTRE DES PAIRES DE PHOTONS INTRIQUÉS EN POLARISATION**
LICHTQUELLE ZUR EMISSION VON IN DER POLARISATION VERSCHRÄNKTEN PHOTONENPAAREN
LIGHT SOURCE ADAPTED TO EMIT PHOTON PAIRS ENTANGLED IN POLARISATION

(30) Priorité: 23.12.2019 FR 1915514
(43) Date de publication de la demande: 30.06.2021
(73) Titulaire: Commissariat à l'Energie Atomique et aux Energies Alternatives, 75015 Paris (FR)
(72) Inventeur: GERARD, Jean-Michel, 38054 GRENOBLE Cedex 09 (FR); CURE, Yoann, 38054 GRENOBLE Cedex 09 (FR); CLAUDON, Julien, 38054 GRENOBLE Cedex 09 (FR)
(74) Mandataire: INNOV-GROUP

(56) Documents cités:
- GB-A- 2 443 220
- M. ZEESHAN ET AL: "Proposed Scheme to Generate Bright Entangled Photon Pairs by Application of a Quadrupole Field to a Single Quantum Dot", PHYSICAL REVIEW LETTERS, vol. 122, no. 22, 7 juin 2019 (2019-06-07) , pages 227401-1, XP055725680, US ISSN: 0031-9007, DOI: 10.1103/PhysRevLett.122.227401
- A. J. BENNETT ET AL: "Electric-field-induced coherent coupling of the exciton states in a single quantum dot", NATURE PHYSICS, vol. 6, no. 12, 3 octobre 2010 (2010-10-03), pages 947-950, XP055225082, GB ISSN: 1745-2473, DOI: 10.1038/nphys1780
- WANG JIANPING ET AL: "Eliminating the fine structure splitting of excitons in self-assembled InAs/GaAs quantum dots via combined stresses", APPLIED PHYSICS LETTERS, A I P PUBLISHING LLC, US, vol. 101, no. 6, 6 août 2012 (2012-08-06), pages 63114-63114, XP012164344, ISSN: 0003-6951, DOI: 10.1063/1.4745188 [extrait le 2012-08-08]
- STEVENSON R M ET AL: "A semiconductor source of triggered entangled photon pairs", NATURE, NATURE PUBLISHING GROUP UK, LONDON, vol. 439, no. 7073, 12 janvier 2006 (2006-01-12), pages 179-182, XP002566712, ISSN: 0028-0836, DOI: 10.1038/NATURE04446
- R. TROTTA ET AL: "Universal Recovery of the Energy-Level Degeneracy of Bright Excitons in InGaAs Quantum Dots without a Structure Symmetry", PHYSICAL REVIEW LETTERS, vol. 109, no. 14, 1 octobre 2012 (2012-10-01), pages 147401-1, XP055725703, US ISSN: 0031-9007, DOI: 10.1103/PhysRevLett.109.147401
- RINALDO TROTTA ET AL: "Wavelength-tunable sources of entangled photons interfaced with atomic vapours", NATURE COMMUNICATIONS, vol. 7, no. 1, 27 janvier 2016 (2016-01-27), pages 10375-1, XP055725715, DOI: 10.1038/ncomms10375
- KOWALIK K ET AL: "Monitoring electrically driven cancellation of exciton fine structure in a semiconductor quantum dot by optical orientation", APPLIED PHYSICS LETTERS, A I P PUBLISHING LLC, US, vol. 91, no. 18, 30 octobre 2007 (2007-10-30), pages 183104-183104, XP012099976, ISSN: 0003-6951, DOI: 10.1063/1.2805025

## Description

### DOMAINE TECHNIQUE

Le domaine de l'invention est celui des sources lumineuses adaptées à émettre des paires de photons intriqués en polarisation.

### ÉTAT DE LA TECHNIQUE ANTÉRIEURE

Il existe des sources de lumières adaptées à émettre à la demande des paires de photons intriqués (ou enchevêtrés) en polarisation, dont les domaines d'application se trouvent par exemple dans la cryptographie, les communications quantiques, le calcul quantique photonique, et la métrologie.

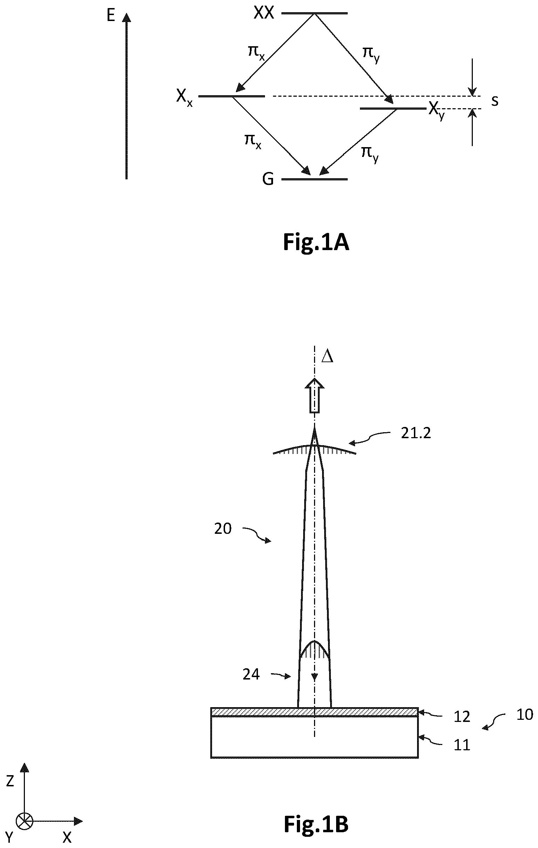

La figure 1A illustre les niveaux d'énergie d'une boîte quantique semiconductrice adaptée à émettre une paire de photons. Une telle boîte quantique présente des niveaux d'énergie discrets du fait du confinement des charges suivant les trois directions de l'espace à une échelle nanométrique, et l'on parle d'un atome artificiel par analogie avec les états électroniques discrets d'un atome.

La boîte quantique peut contenir deux paires électron-trou dans un état dit biexcitonique XX. Du fait du principe de Pauli, les électrons présentent des états de spin différents, ainsi que les trous. La durée de vie d'un état biexcitonique XX étant finie, ces deux paires électron-trou se recombinent de manière radiative par cascade à deux photons, passant ainsi de l'état biexcitonique XX à l'état fondamental G via des états excitoniques Xₓ et X_{y} intermédiaires.

À ces transitions excitoniques de XX vers Xₓ ou X_{y}, et de Xₓ ou X_{y} vers G, sont associés des dipôles optiques à polarisations linéaires et orthogonales entre elles, notées πₓ et π_{y}. Les indices x et y correspondent ici aux axes optiques orthogonaux entre eux suivant lesquels ces dipôles optiques sont orientés.

Aussi, une première paire électron-trou se recombine en passant de l'état biexcitonique XX à l'un des états excitoniques, par exemple Xₓ, en émettant un photon à polarisation linéaire πₓ ; puis la deuxième paire électron-trou se recombine en passant de l'état excitonique Xₓ à l'état fondamental G en émettant un photon à polarisation linéaire ici nécessairement πₓ. Cependant, la première paire électron-trou peut également se recombiner en rejoignant l'état excitonique X_{y} et en émettant un photon à polarisation linéaire π_{y}, auquel cas la deuxième paire électron-trou se recombinera ensuite en émettant un photon à polarisation linéaire π_{y}.

Si les deux états excitoniques Xₓ et X_{y} sont dégénérés en énergie, c'est-à-dire s'ils présentent sensiblement le même niveau d'énergie, les chemins de recombinaison radiative sont indiscernables et les photons sont alors dits intriqués en polarisation. Quelle que soit la base de polarisation (linéaire ou circulaire) dans laquelle on effectue les mesures, la détermination de la polarisation d'un des photons de la paire permet de connaître exactement la polarisation de l'autre photon, sans la mesurer. Plus précisément, les photons présentent un haut degré d'intrication en polarisation lorsque la différence S entre les niveaux d'énergie des états excitoniques Xₓ et X_{y}, appelée séparation en énergie ou séparation de structure fine, est nulle.

Cependant, la boîte quantique peut présenter une séparation en énergie S non nulle. Si la séparation en énergie S est plus petite que la largeur des raies d'émission des transitions excitoniques, le degré d'intrication est réduit. Si la séparation en énergie S est plus grande que celle-ci, les deux chemins de recombinaison XX-Xₓ-G et XX-X_{y}-G donnent des raies d'émission que l'on peut distinguer dans le domaine spectral, puisqu'elles ne se recouvrent pas. Dans ce cas, il est connu que les polarisations des deux photons émis ne sont corrélées que lorsque les mesures sont effectuées dans la base de polarisation linéaire (πₓ, π_{y}). Il n'y a par exemple aucune corrélation dans la base de polarisation circulaire : les photons ne présentent alors aucun degré d'intrication. On cherche alors à réduire la valeur de la séparation en énergie S pour améliorer le degré d'intrication de la paire de photons émis.

À ce titre, la publication de Trotta et al. intitulée *Energy-Tunable Sources of Entangled Photons: A Viable Concept for Solid-State-Based Quantum Relays,* Phys. Rev. Lett. **114**, 150502 (2015) décrit un exemple de source de lumière adaptée à émettre des paires de photons. L'intrication en polarisation des photons est obtenue au moyen d'un dispositif de correction de la séparation en énergie S via l'application d'une contrainte mécanique anisotrope à une boîte quantique semiconductrice, modifiant ainsi les propriétés électroniques de celle-ci. Ce dispositif de correction comporte un actionneur piézoélectrique à six bras permettant d'appliquer une contrainte mécanique anisotrope à la boîte quantique située dans une membrane.

Cependant, cette source de lumière ne permet pas d'émettre des paires de photons intriqués en polarisation suivant une direction d'émission contrôlée et à haute efficacité d'extraction, cette directivité et efficacité d'extraction étant requises pour obtenir notamment un couplage efficace à une fibre optique.

La publication de Dousse et al. intitulée *Ultrabright source of entangled photon pairs,* Nature 466, 217 (2010) décrit une source de lumière adaptée à émettre une paire de photons intriqués, selon une première configuration dans laquelle une boîte quantique semiconductrice est située dans une cavité optique résonante. Plus précisément, la source de lumière comporte deux cavités optiques résonantes, couplées l'une à l'autre, qui forment ensemble une cavité optique doublement résonante aux longueurs d'onde des états biexcitonique et excitoniques. Le procédé de fabrication de cette source de lumière comporte une étape de recuit permettant de réduire la valeur de la séparation en énergie S à quelques microélectron-volts, de sorte que l'intrication des photons en polarisation est obtenue structurellement et ne peut être ajustée de manière contrôlée jusqu'à être annulée.

La publication de Jöns et al. intitulée *Bright nanoscale source of deterministic entangled photon pairs violating Bell's inequality,* Sci Rep **7**, 1700 (2017) décrit une source de lumière adaptée à émettre une paire de photons partiellement intriqués, selon une deuxième configuration dans laquelle une boîte quantique semiconductrice est placée dans un fil photonique formant un guide d'onde monomode. La figure 1B illustre de manière schématique un tel fil photonique 20 qui repose sur un substrat 10. Le substrat 10 comporte une couche réflectrice 12 en regard de laquelle est disposé le fil photonique 20. Celui-ci est réalisé en un matériau de haut indice de réfraction, ici de l'InP, et contient une boîte quantique 24 en InAsP. Il présente des dimensions transversales de sorte qu'il supporte un seul mode optique guidé. De plus, il comporte un adaptateur de mode, ici par une forme générale effilée vers l'extrémité supérieure, de manière à améliorer l'efficacité d'extraction lumineuse suivant la direction +Z. Pour ce choix de matériaux, la séparation en énergie S est suffisamment petite pour que les photons soient partiellement intriqués notamment du fait que la boîte quantique est hautement symétrique dans le plan XY. Cependant, cette source ne dispose pas de moyen de réduire et d'annuler la séparation en énergie S, et donc de maximiser le degré d'intrication.

Dans ce contexte, la publication de Zeeshan et al. intitulée *Proposed Scheme to Generate Bright Entangled Photon Pairs by Application of a Quadrupole Field to a Single Quantum Dot,* Phys. Rev. Lett. **122,** 227401 (2019) décrit un dispositif permettant d'engendrer une paire de photons intrinqués à partir d'une boîte quantique unique par l'application d'un potentiel électrostatique quadripolaire adéquat. Il est ainsi démontré qu'un champ électrique quadripolaire adapté permet de corriger l'asymétrie spatiale de la fonction d'onde excitonique pour toute orientation dipolaire des boîtes quantiques et d'effacer complètement la séparation de structure fine S sans compromettre le chevauchement spatial entre électrons et trous. Cette approche, compatible avec les structures nanophotoniques telles que microcavités et nanofils, ouvre la voie vers une source déterministe de photons intriqués.

Aussi, il existe un besoin de disposer d'une source de lumière adaptée à émettre des paires de photons présentant une efficacité élevée d'extraction lumineuse et une directivité d'émission, dont on puisse ajuster et réduire de manière contrôlée la séparation en énergie S pour améliorer le degré d'intrication en polarisation de la paire de photons émis.

### EXPOSÉ DE L'INVENTION

L'invention a pour objectif de remédier au moins en partie aux inconvénients de l'art antérieur, et plus particulièrement de proposer une source de lumière permettant d'émettre des paires de photons intriqués en polarisation suivant une direction d'émission définie et avec une efficacité élevée d'extraction lumineuse, dont la séparation en énergie S entre les niveaux d'énergie des états excitoniques Xₓ et X_{y} peut être ajustée et réduite de manière contrôlée, améliorant ainsi le degré d'intrication en polarisation de la paire de photons émis.

Pour cela, l'objet de l'invention est une source de lumière adaptée à émettre une paire de photons intriqués en polarisation, comportant :
- un substrat, comportant une couche réflectrice ;
- un fil photonique, comportant un cœur présentant un indice de réfraction n_{c} et étant : disposé sur le substrat en regard de la couche réflectrice, et s'étendant longitudinalement suivant un axe principal Δ sensiblement orthogonal au plan du substrat ; comportant un émetteur, adapté à émettre une paire de photons destinés à être intriqués en polarisation ; présentant des dimensions transversales, dans un plan parallèle au substrat et contenant l'émetteur, telles que le cœur forme un guide d'onde monomode pour les photons émis, le mode optique guidé étant dégénéré en polarisation ; ces dimensions transversales variant longitudinalement en direction d'une extrémité supérieure du cœur, de manière à former un adaptateur de mode pour le mode optique guidé ;
- un dispositif d'excitation optique, adapté à exciter l'émetteur et ainsi à provoquer une émission spontanée par l'émetteur d'au moins une paire de photons.

Selon l'invention, le fil photonique comporte en outre une gaine présentant un indice de réfraction n_{g} inférieur à n_{c}, et s'étendant dans un plan parallèle au substrat à partir du cœur, et présentant une dimension maximale par rapport à l'axe principal Δ définissant un axe transversal principal At_{g} de sorte qu'elle présente une asymétrie de révolution autour de l'axe principal Δ.

De plus, la source de lumière comporte un dispositif de correction, adapté à induire par effet électrostatique une déformation mécanique du fil photonique dans un plan parallèle au substrat, suivant un axe de déformation Ad formant un angle d'inclinaison compris entre 0° et 90°, ces valeurs étant exclues, vis-à-vis de l'axe transversal principal At_{g}, la déformation mécanique se traduisant par des contraintes mécaniques subies par l'émetteur, améliorant ainsi le degré d'intrication de la paire de photons.

Certains aspects préférés mais non limitatifs de cette source de lumière sont les suivants.

Le dispositif de correction peut comporter : au moins deux électrodes adaptées à générer un champ électrique non uniforme, et agencées de part et d'autre du fil photonique de sorte que le fil photonique présente une distance Dₚ à l'une des électrodes dite proximale inférieure à une distance D_{d} à l'autre électrode dite distale, l'axe de déformation Ad étant défini comme passant par une extrémité de l'électrode proximale orientée vers le fil photonique et l'axe principal Δ; et une source de tension électrique, connectée aux électrodes, pour générer ledit champ électrique, la valeur de la tension étant prédéfinie de sorte que la paire de photons est intriquée en polarisation.

Le dispositif de correction peut comporter des piliers reposant sur le substrat et distincts du fil photonique, sur lesquels reposent les électrodes ; le cœur du fil photonique et les piliers étant réalisés à base d'un même matériau cristallin.

Le cœur du fil photonique et les piliers peuvent présenter une même hauteur vis-à-vis du substrat.

L'émetteur peut présenter un état biexcitonique XX, deux états excitoniques Xx, Xy et un état fondamental G, deux dipôles optiques étant associés aux transitions excitoniques entre l'état biexcitonique XX et les états excitoniques Xx, Xy, et entre les états excitoniques Xx, Xy, et l'état fondamental G, les dipôles optiques présentant des polarisations linéaires orientées suivant des axes optiques x, y orthogonaux entre eux et étant situés dans un plan parallèle au substrat, l'axe de déformation Ad étant sensiblement aligné sur l'un des axes optiques x, y.

L'émetteur peut être situé sur l'axe principal Δ, à 20nm près.

Le cœur du fil photonique peut présenter une symétrie de rotation autour de l'axe principal Δ d'ordre égal à 4.

Le cœur du fil photonique peut être réalisé à base d'un matériau cristallin choisi parmi les composés III-V ou les composés II-VI, et l'émetteur peut être formé d'au moins une boîte quantique semiconductrice.

L'invention porte également sur un procédé de fabrication d'une source de lumière selon l'une quelconque des caractéristiques précédentes, dans lequel :
- on réalise un empilement comportant : un substrat, comportant une couche réflectrice revêtue d'une couche transparente d'arrêt de gravure ; et une première et une deuxième couche, reposant sur la couche transparente, réalisées en un matériau cristallin d'indice de réfraction n_{c}, entre lesquelles est situé l'émetteur ;
- on réalise le cœur du fil photonique par gravure localisée de l'empilement ;
- on réalise la gaine de sorte qu'elle s'étende à partir du cœur suivant un axe transversal principal At_{g} dans un plan parallèle au plan du substrat.

La gaine peut être réalisée par dépôt physique en phase vapeur suivant une direction de dépôt parallèle à l'axe transversal principal At_{g} souhaité et formant un angle d'inclinaison vis-à-vis du plan du substrat inférieur à 90°, et de préférence inférieur ou égal à 20°.

La gaine peut être réalisée par dépôt d'une couche diélectrique d'encapsulation entourant le cœur du fil photonique dans un plan parallèle au substrat sur toute la hauteur du cœur, lithographie puis gravure localisée de la couche diélectrique d'encapsulation.

Lors de la réalisation du cœur du fil photonique, des piliers peuvent être réalisés simultanément par gravure localisée de l'empilement. On peut réaliser au moins deux électrodes sur des faces supérieures des piliers, lesdites électrodes étant disposées de part et d'autre du cœur du fil photonique.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
la figure 1A, déjà décrite, illustre les niveaux d'énergie de l'état biexcitonique XX et des états excitoniques Xₓ et X_{y} par rapport à l'état fondamental G d'un émetteur adapté à émettre une paire de photons ;
la figure 1B, déjà décrite, est une vue schématique et partielle, en coupe transversale, d'une source de paire de photons intriqués en polarisation selon un exemple de l'art antérieur dans lequel l'émetteur est situé dans un fil photonique formant un guide d'onde monomode ;
les figures 2A et 2B sont des vues schématiques et partielles, en coupe transversale (fig.2A) et en vue de dessus (fig.2B), d'une source de lumière selon un mode de réalisation dans lequel le cœur du fil photonique présente une forme évasée (trompette photonique) ;
la figure 3A illustre un exemple d'évolution de la déformation ε subie par une boîte quantique en fonction de sa position transversale d_{BQ} vis-à-vis d'un axe principal Δ, la boîte quantique étant située dans un fil photonique formé d'un cœur non revêtu par une gaine à asymétrie de révolution (ou asymétrie axiale), lorsque l'extrémité supérieure du fil photonique a été déplacée dans le plan XY ;
la figure 3B illustre un exemple d'évolution d'un déplacement δ de l'extrémité supérieure du fil photonique dans un plan XY en fonction d'une tension électrique U appliquée, dans le cas d'un fil photonique formé d'un cœur non revêtu par une gaine, et dans le cas d'un fil photonique formé d'un cœur et d'une gaine à asymétrie de révolution ;
la figure 3C illustre un exemple d'évolution des déformations ε_{XX} et ε_{YY} subies par une boîte quantique dans un plan XY en fonction de sa position transversale d_{BQ} vis-à-vis d'un axe principal Δ, la boîte quantique étant située dans un fil photonique formé d'un cœur et d'une gaine à asymétrie de révolution, lorsque l'extrémité supérieure du fil photonique a été déplacée dans le plan XY ;
la figure 3D illustre un exemple d'évolution du déplacement δ dans un plan XY de l'extrémité supérieure d'un fil photonique formé d'un cœur et d'une gaine à asymétrie de révolution d'une part, et de l'écart ΔS de la séparation en énergie S vis-à-vis de la valeur S₀ hors contrainte, en fonction de la tension électrique U appliquée ;
la figure 4A est une vue schématique et partielle d'une source de lumière comportant un dispositif d'excitation optique et un dispositif de collection selon un mode de réalisation ; et
la figure 4B est une vue schématique et partielle d'une source de lumière comportant un dispositif d'excitation optique selon une variante de réalisation ;
les figures 5A à 5F illustrent différentes étapes d'un procédé de fabrication d'une source de lumière selon un mode de réalisation similaire à celui illustré sur les fig.2A et 2B ;
la figure 6 est une vue schématique et partielle, en coupe transversale, d'une source de lumière selon un autre mode de réalisation dans lequel le fil photonique présente une forme effilée ;
la figure 7 est une vue schématique et partielle, en coupe transversale (gauche) et en vue de dessus (droite) d'un fil photonique selon une variante de réalisation dans laquelle la gaine asymétrique a été réalisée par lithographie et gravure d'une couche d'encapsulation initiale ;
la figure 8 est une vue schématique et partielle, en vue de dessus, d'une source de lumière selon une variante de réalisation comportant au moins trois électrodes ;
les figures 9A et 9B sont des vues schématiques et partielles, en vue de dessus, d'un fil photonique dans lequel la gaine à asymétrie de révolution présente différentes configurations.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur une source de lumière adaptée à émettre au moins une paire de photons et permettant d'ajuster le degré d'intrication en polarisation des photons émis. Elle est ainsi adaptée à émettre à la demande, par émission spontanée, une paire de photons dont l'état quantique de l'un des photons est indissociable de l'état quantique de l'autre photon. Par état quantique d'un photon, on entend les propriétés du photon en termes de polarisation, de fréquence et de forme du paquet d'onde. Dans cet exemple, les photons sont dits intriqués (*entangled,* en anglais) lorsque l'état de polarisation de l'un des photons est défini par l'état de polarisation de l'autre photon, quelle que soit la base de polarisation choisie pour effectuer la mesure de leurs états de polarisation.

La source de lumière comporte un fil photonique formant un guide d'onde monomode du type de celui décrit précédemment sur la fig.1B au sein duquel se situe un émetteur de photons formant un atome artificiel. L'émetteur de photons est assimilable à un système quantique électronique à deux niveaux. Un tel émetteur de photons uniques présente ainsi des niveaux d'énergie discrets, et l'on parle alors d'un atome artificiel, par analogie avec les états électroniques discrets d'un atome. Un tel émetteur peut être une boîte quantique semiconductrice, dont le confinement des charges suivant les trois directions de l'espace à une échelle nanométrique rend les niveaux d'énergie discrets.

Compte tenu du degré de liberté de spin, chaque état électronique de l'atome artificiel peut contenir 0, 1 ou 2 électrons. Comme expliqué dans l'article de Benson et al. intitulé *Regulated and Entangled Photons from a Single Quantum Dot,* Phys. Rev. Lett. **84**, 2513-2516 (2000), l'émission de paires de photons intriqués peut être décrite en considérant quatre états d'excitation différents de l'atome artificiel : l'état fondamental G pour lequel aucun électron n'est dans le niveau supérieur ; deux états excitoniques Xₓ et X_{y} dont les énergies Eₓ et E_{y} sont proches mais en général différentes, et pour lesquels un électron est dans le niveau supérieur ; enfin un état biexcitonique XX pour lequel deux électrons sont dans le niveau supérieur, aucun dans le niveau inférieur, et dont l'énergie Eₓₓ est proche de 2Eₓ.

Lorsque l'atome artificiel est constitué par des matériaux semiconducteurs, on utilise habituellement la terminologie de trou pour qualifier une absence d'électron, et la terminologie d'exciton pour parler d'une excitation élémentaire constituée par un électron dans le niveau supérieur et un trou dans le niveau inférieur. En utilisant cette terminologie, l'émetteur peut contenir une première paire électron-trou (exciton), ou deux paires électron-trou (biexciton). S'il est dans cet état biexcitonique XX, il relaxe spontanément vers l'un des deux états excitoniques Xₓ ou X_{y} puis vers l'état fondamental G en émettant une paire de photons. En raison notamment de l'interaction coulombienne entre les paires électron-trou, les différences d'énergie entre les transitions (biexciton/exciton, et exciton/fondamental) sont différentes, de sorte que les photons émis présentent des longueurs d'onde différentes.

Comme indiqué précédemment, à chaque transition excitonique XX-Xₓ et Xₓ-G est associé un dipôle optique dₓ, et à chaque transition excitonique XX-X_{y} et X_{y}-G est associé un dipôle optique d_{y}, ces deux dipôles optiques dₓ et d_{y} étant de plus orientés suivant des axes optiques notés x et y, contenus dans le plan de la boîte quantique (parallèle au plan du substrat), et mutuellement orthogonaux. Ces axes optiques x et y définissent l'orientation de la polarisation linéaire en champ lointain.

Dans la suite de la description, l'émetteur de photons uniques est une boîte quantique semiconductrice, formée d'un îlot nanométrique d'un composé semiconducteur cristallin, par exemple de l'InAs, isolé dans un matériau cristallin de haut indice, par exemple du GaAs, qui forme le cœur du fil photonique. Aussi, à basse température (quelques kelvins par exemple), une impulsion laser courte devant la durée de vie radiative de la boîte quantique permet de créer un biexciton dans la boîte quantique, et donc de faire passer celle-ci de son état fondamental G à son état biexcitonique XX. La boîte quantique ne comporte pas, au repos, c'est-à-dire à l'état relaxé, d'électron ou de trou. Pour cela, elle est intrinsèque, c'est-à-dire non intentionnellement dopée.

Cependant, comme indiqué précédemment, l'émetteur présente en général, en l'absence de perturbation extérieure (par ex. juste après fabrication, *as-grown* en anglais) une séparation en énergie S de valeur S₀ non nulle, c'est-à-dire que la différence d'énergie entre les états excitoniques Xₓ et X_{y} est supérieure à la largeur des raies d'émission associées à ces transitions excitoniques. Comme détaillé par la suite, la source de lumière selon l'invention permet d'ajuster la séparation en énergie S de manière contrôlée pour la réduire et voire l'annuler, de préférence à mieux que la largeur des raies d'émission près, et ainsi d'améliorer voire maximiser l'intrication en polarisation de la paire de photons.

Le degré d'intrication en polarisation de la paire de photons est ici associé, d'une part, à la valeur de la séparation en énergie S, et d'autre part à la différence entre les durées de vie des excitons Xₓ et X_{y}. Ainsi, maximiser le degré d'intrication revient à réduire, et de préférence annuler, la séparation en énergie S d'une part, et à rendre sensiblement égales les durées de vie des excitons Xₓ et X_{y} d'autre part. Dans le cadre de l'invention, la source de lumière permet de réduire et d'annuler de manière contrôlée la séparation en énergie S, tout en obtenant des excitons Xₓ et X_{y} de durées de vie sensiblement égales, maximisant ainsi le degré d'intrication de la paire de photons.

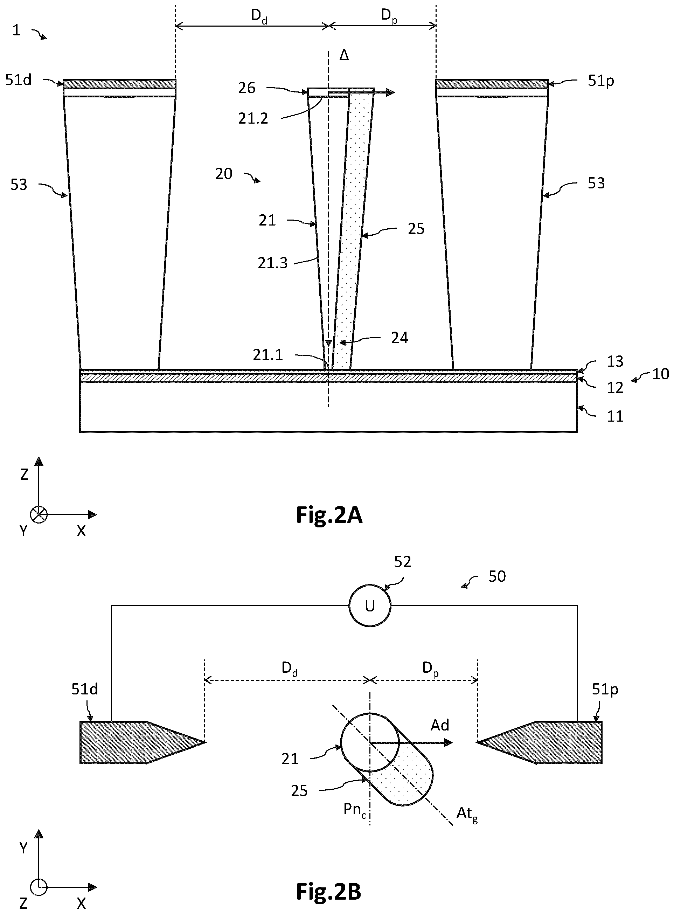

Les figures 2A et 2B sont des vues schématiques et partielles, respectivement en coupe et en vue de dessus, d'une source de lumière 1 selon un mode de réalisation, adaptée à contrôler le degré d'intrication de la paire de photons, et ainsi à émettre des paires de photons intriqués en polarisation.

D'une manière générale, la source de lumière 1 comporte un fil photonique 20 qui repose sur un substrat 10, et un dispositif de correction 50 adapté à déformer le fil photonique 20 par effet électrostatique et ainsi à générer des contraintes mécaniques subies par l'émetteur 24 telles que le degré d'intrication de la paire de photons est amélioré. Elle comporte également un dispositif d'excitation optique 30 adapté à provoquer l'émission spontanée d'une paire de photons par l'émetteur 24, et elle peut comporter un dispositif de collection 40 adapté à assurer la collection optique des photons émis et par exemple à assurer un couplage optique entre le fil photonique 20 et un guide d'onde externe 43.

Dans ce premier mode de réalisation, le cœur 21 du fil photonique 20 présente une forme générale évasée en direction de son extrémité supérieure, c'est-à-dire qu'il présente un élargissement de son diamètre local à mesure que l'on s'éloigne du substrat 10. Le cœur 21 du fil photonique 20 forme alors une « trompette photonique », selon l'expression donnée notamment dans l'article de Munsch et al. intitulé Dielectric GaAs Antenna Ensuring an Efficient Broadband Coupling between an InAs Quantum-Dot and a Gaussian Optical Beam, Phys. Rev. Lett. 110, 177402 (2013). Par ailleurs, l'émetteur 24 de la paire de photons, autrement dit l'atome artificiel, est une boîte quantique réalisée en un matériau semiconducteur intrinsèque et située dans le matériau cristallin de haut indice à base duquel est formé le cœur 21 du fil photonique 20.

On définit ici et pour la suite de la description un repère direct tridimensionnel orthogonal XYZ, où les axes X et Y forment un plan parallèle au plan principal du substrat 10, et où l'axe Z est orienté en direction du fil photonique 20 et est parallèle à l'axe principal de ce dernier. Par ailleurs, les termes « inférieur » et « supérieur » s'entendent comme étant relatifs à un positionnement croissant lorsqu'on s'éloigne du substrat 10 suivant la direction +Z.

Le substrat 10 est un support sur lequel repose le fil photonique 20. Il est formé d'une couche principale 11 épaisse, de préférence rigide, réalisée en un ou plusieurs matériaux. La couche principale 11 peut être une plaque semiconductrice (*wafer*, en anglais) présentant par exemple une épaisseur d'une à plusieurs centaines de microns. Elle peut ici être réalisée en GaAs, dopé ou non.

Une couche réflectrice 12 revêt au moins localement la couche principale 11. Elle est située sous le fil photonique 20 et est adaptée à réfléchir les photons émis par l'émetteur 24 du fil photonique 20. La couche réflectrice 12 peut être réalisée en un matériau métallique, par exemple de l'or d'une épaisseur comprise par exemple entre 100nm et 300nm.

Une couche diélectrique 13 revêt ici la couche réflectrice 12 et la couche principale 11. Elle est réalisée en un matériau diélectrique et peu absorbant à la longueur d'onde d'émission λₑ, et forme avantageusement une couche d'arrêt de gravure vis-à-vis d'agents de gravure utilisés lors de différentes étapes de gravure mises en œuvre par le procédé de fabrication de la source de lumière 1. La couche diélectrique 13 peut être réalisée notamment en un nitrure de silicium, par exemple du Si₃N₄ d'une épaisseur de 9 à 11nm environ. En variante, comme indiqué plus loin, la couche diélectrique 13 peut être remplacée par une couche transparente réalisée en un matériau électriquement conducteur, tel que de l'ITO, notamment lorsqu'est effectuée une excitation de l'émetteur 24 par injection électrique.

Le fil photonique 20 repose sur le substrat 10 et est disposé en regard de la couche réflectrice 12, c'est-à-dire à sa verticale suivant l'axe Z. D'une manière générale, le cœur 21 du fil photonique 20 se présente sous la forme d'un élément tridimensionnel allongé suivant un axe principal Δ sensiblement orthogonal au plan XY du substrat 10. Autrement dit, il présente une dimension longitudinale (hauteur h) suivant l'axe principal Δ supérieure aux dimensions transversales. Le fil photonique 20 est formé du cœur 21 présentant un haut indice de réfraction n_{c} et d'une gaine 25 entourant au moins partiellement le cœur 21 et présentant un faible indice de réfraction n_{g}, c'est-à-dire un indice de réfraction n_{g} inférieur à n_{c}.

L'axe principal Δ est défini comme étant orthogonal au plan XY et passant par les barycentres des sections droites du cœur 21 du fil photonique 20 dans des plans XY, dans le cas où le fil photonique 20 est mécaniquement au repos, c'est-à-dire non déformé dans le plan XY.

Le cœur 21 du fil photonique 20 forme un guide d'onde monomode à la longueur d'onde d'émission λₑ, c'est-à-dire qu'il supporte un seul mode optique guidé, par exemple le mode fondamental. De plus, le cœur 21 du fil photonique 20 est dimensionné de sorte que le mode optique guidé est dégénéré en polarisation, c'est-à-dire qu'il supporte deux modes fondamentaux à polarisations linéaires orthogonales entre elles et de même indice effectif, ou, de façon équivalente, deux modes fondamentaux à polarisations circulaires de sens opposés et de même indice effectif.

Pour cela, il présente des dimensions transversales, dans le plan XY contenant l'émetteur 24, choisies de manière à obtenir le caractère monomode du guide d'onde. Plus précisément, il présente un diamètre local, dans la section droite contenant l'émetteur 24, sensiblement égale à λ_{e/}n_{c}. Dans le cas d'une boîte quantique 24 en InAs adaptée à émettre des photons à une longueur d'onde λₑ de 950nm environ, le diamètre local du cœur 21 du fil photonique 20 au niveau de la boîte quantique 24 est compris entre 150nm et 300nm environ, de préférence égal à 200nm environ.

La forme de la section droite du cœur 21 du fil photonique 20 dans le plan XY est choisie de sorte que le cœur 21 du fil photonique 20 supporte un mode fondamental dégénéré en polarisation. Ceci est obtenu par le fait que la section droite du cœur 21 présente une symétrie de rotation autour de l'axe principal Δ d'ordre 4. Cela couvre donc toutes les symétries de rotation autour de l'axe principal Δ compatibles avec l'ordre 4, c'est-à-dire les symétries de rotation d'ordre 8, 12..., mais également la symétrie axiale (i.e. de révolution). Il peut ainsi s'agir d'un carré, d'un octogone, d'un dodécagone, d'un disque, ou de toute autre forme non polygonale ou circulaire et vérifiant la symétrie de rotation autour de l'axe principal Δ d'ordre 4. De préférence, la section droite est circulaire le long de l'axe principal Δ, de sorte que le cœur 21 supporte deux modes fondamentaux dégénérés, que l'on choisisse de les décrire dans une base de polarisations linéaires ou circulaires.

Par section droite, on entend ici une section du cœur 21 du fil photonique 20 dans un plan XY parallèle au substrat 10 et donc orthogonal à l'axe principal Δ. Les dimensions transversales sont définies par un diamètre équivalent associé à la section droite du cœur 21 du fil photonique 20. Il peut s'agir du diamètre d'un disque présentant la même surface que la section droite du fil photonique 20. Le diamètre local est le diamètre du cœur 21 du fil photonique 20 pour une section droite à une hauteur donnée de celui-ci. Le diamètre moyen est la moyenne, par exemple arithmétique, des diamètres locaux le long du cœur 21 du fil photonique 20 ou d'une portion de celui-ci.

Les dimensions transversales (diamètre local) du cœur 21 du fil photonique 20, c'est-à-dire ses dimensions dans un plan XY, peuvent être par exemple comprises entre 10nm et 5µm, et de préférence comprises entre 100nm et 2µm. Dans la mesure où les dimensions transversales du cœur 21 du fil photonique 20 présentent une augmentation suivant la direction +Z, la hauteur du fil photonique 20 est supérieure aux dimensions transversales maximales du cœur 21, par exemple 2 fois, et de préférence au moins 5 fois supérieure. La hauteur h est définie comme étant la distance, suivant l'axe Z, entre l'extrémité inférieure du fil photonique 20 au contact du substrat 10 et son extrémité supérieure. L'extrémité inférieure et l'extrémité supérieure du cœur 21 du fil photonique 20 sont reliées entre elles par une bordure latérale.

Par ailleurs, le cœur 21 du fil photonique 20 est réalisé à base d'un matériau cristallin de haut indice de réfraction n_{c}, ici du GaAs d'indice de réfraction n_{c} égal à 3.45. Il est entouré d'un environnement de bas indice de réfraction. Il s'agit au moins en partie de la gaine 25 (décrite en détail plus loin) d'indice de réfraction n_{g} inférieur à n_{c} et qui s'étend au moins partiellement autour et au contact du cœur 21 dans le plan XY, et éventuellement du vide ou d'un gaz. Dans le cas où l'émetteur 24 est une boîte quantique semiconductrice, le matériau cristallin de haut indice est choisi en fonction du composé semiconducteur de la boîte quantique. Ainsi, le matériau cristallin de haut indice peut être un composé III-V, par exemple du GaAs ou de l'InP lorsque la boîte quantique 24 est réalisée en InAs, ou de l'AlN lorsque la boîte quantique 24 est réalisée en GaN. Dans ce premier mode de réalisation, le cœur 21 du fil photonique 20 est réalisé en GaAs et comporte au moins une boîte quantique 24 en InAs. D'autres combinaisons de matériaux sont possibles, tant parmi les composés III-V que parmi les composés II-VI, en fonction de la longueur d'onde d'émission λₑ souhaitée. En variante, l'émetteur 24 peut être une boîte quantique formée par une fluctuation d'épaisseur locale d'un puits quantique comme décrit dans l'article de Hours et al. intitulé Single photon emission from individual GaAs quantum dots, Appl. Phy. Lett. 82, 2206 (2003).

Il peut également s'agir d'une boîte quantique de GaAs dans un fil photonique en GaAlAs en utilisant, comme mode de fabrication de la boîte quantique, l'épitaxie assistée par goutte (*droplet epitaxy,* en anglais) comme décrit dans l'article de Gurioli et al. intitulé Droplet epitaxy of semiconductor nanostructures for quantum photonic devices, Nat. Mater. 18, 799-810 (2019).

L'émetteur 24 est adapté à émettre par émission spontanée une paire de photons par transition biexciton/exciton et transition exciton/fondamental. Il possède donc deux dipôles optiques dₓ, d_{y} orientés respectivement suivant des axes optiques x et y orthogonaux entre eux et situés dans le plan XY. Dans cet exemple, il s'agit d'une boîte quantique réalisée en un composé cristallin semiconducteur intrinsèque (non intentionnellement dopé) dont l'énergie de bande interdite détermine la longueur d'onde λₑ des photons émis.

De préférence, le fil photonique 20 ne comporte qu'une seule boîte quantique 24, disposée de préférence sur l'axe principal Δ du cœur 21 du fil photonique 20, à 20 nm près. Le fait qu'elle soit située sur l'axe principal Δ, à 20nm près, permet de rendre sensiblement égales les durées de vie des excitons Xₓ et X_{y}, participant ainsi à améliorer le degré d'intrication de la paire de photons.

Il peut ainsi s'agir d'une boîte quantique 24 en InAs disposée dans une couche continue dite de mouillage en InAs qui s'étend dans un plan parallèle au plan XY. En variante, le fil photonique 20 peut comporter plusieurs boîtes quantiques disposées dans une même couche continue de mouillage. La boîte quantique 24 est de préférence disposée à une hauteur de 100nm environ vis-à-vis du substrat 10, où le diamètre local du cœur 21 du fil photonique 20 est de préférence égal à 200nm environ. Dans le cas où l'émetteur 24 est formé de plusieurs boîtes quantiques, celles-ci peuvent ne pas présenter des dimensions rigoureusement identiques, et peuvent alors émettre des photons à des longueurs d'onde légèrement différentes. Dans ce cas, comme décrit plus loin, le dispositif de collection 40 comporte avantageusement un filtre spectral 41 pour ne transmettre que les photons émis par la boîte quantique 24 choisie.

Par ailleurs, le cœur 21 du fil photonique 20 comporte un adaptateur de mode permettant d'optimiser l'extraction lumineuse du mode guidé hors du fil photonique 20 et d'obtenir un diagramme d'émission de forme gaussienne à faible ouverture numérique. Plus précisément, le cœur 21 du fil photonique 20 présente une variation longitudinale du diamètre local en direction de l'extrémité supérieure, de manière à dé-confiner progressivement le mode guidé, permettant ainsi d'obtenir un diagramme d'émission en champ lointain plus directif, et ainsi adapté à un couplage efficace avec un guide d'onde externe. Ainsi, le diamètre local passe, de préférence d'une manière monotone, d'un premier extremum à son extrémité inférieure 21.1 ou à partir d'une hauteur donnée, à un deuxième extremum différent du premier au niveau de l'extrémité supérieure 21.2.

Dans ce mode de réalisation, le cœur 21 du fil photonique 20 présente une forme évasée, dans le sens où son diamètre local passe, suivant la direction +Z, d'une valeur minimale dₘᵢₙ à une valeur maximale dₘₐₓ située à l'extrémité supérieure 21.2. La variation longitudinale peut être monotone et linéaire. Dans cet exemple, le cœur 21 du fil photonique 20 présente une forme générale évasée, dans le sens où la valeur minimale dₘᵢₙ est située au niveau de l'extrémité inférieure 21.1, et le diamètre local augmente de manière monotone et sensiblement linéaire de dₘᵢₙ à dₘₐₓ. En variante (non représentée), le cœur 21 du fil photonique 20 peut présenter une forme évasée sur une hauteur donnée seulement, et non pas sur toute la hauteur du fil. Aussi, dans ce cas de figure, le diamètre local reste tout d'abord sensiblement constant et égal à dₘᵢₙ sur une hauteur non nulle à partir de l'extrémité inférieure 21.1, puis augmente jusqu'à la valeur maximale dₘₐₓ à l'extrémité supérieure 21.2.

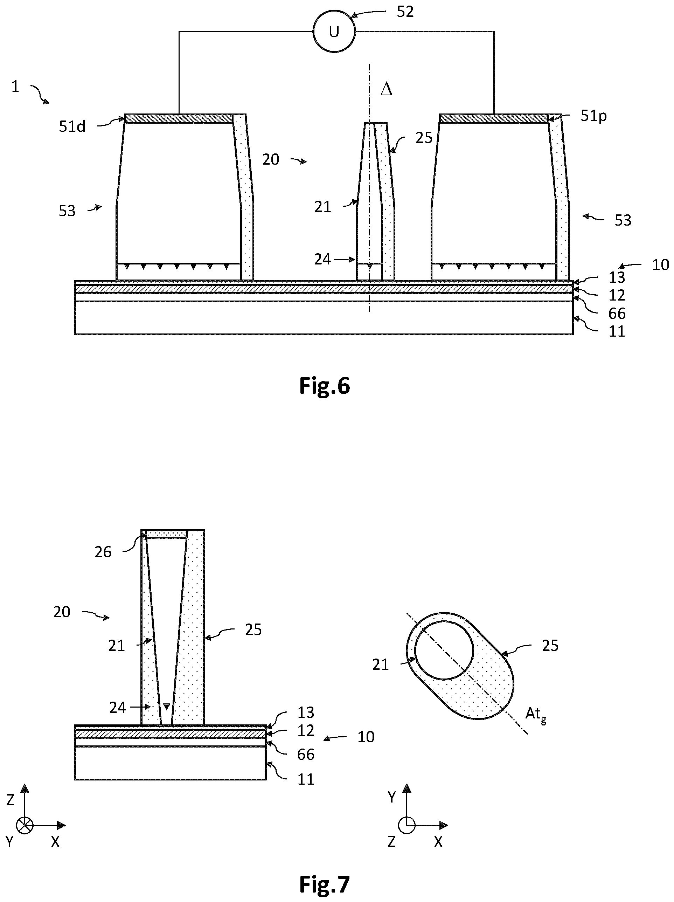

En variante, et comme décrit en détail plus loin (cf. fig.6), le cœur 21 du fil photonique 20 peut présenter une forme effilée, dans le sens où le diamètre local passe, suivant la direction +Z, d'une valeur maximale dₘₐₓ à une valeur minimale dₘᵢₙ située à l'extrémité supérieure 21.2. La variation longitudinale peut être monotone et linéaire. Le cœur 21 du fil photonique 20 peut présenter une forme effilée sur toute la hauteur du fil, ou sur une partie du fil seulement. Dans ce dernier cas, suivant la direction +Z, le diamètre local reste tout d'abord sensiblement constant et égal à dₘₐₓ sur une hauteur non nulle, puis diminue jusqu'à l'extrémité supérieure 21.2 qui présente un diamètre local égal à dₘᵢₙ.

À titre d'exemple, dans ce mode de réalisation où le cœur 21 du fil photonique 20 présente une forme générale évasée, le cœur 21 du fil photonique 20 peut présenter une hauteur de l'ordre de 12µm environ, un diamètre local maximal dₘₐₓ de 1.5µm environ à l'extrémité supérieure, la boîte quantique 24 étant située à une distance de 100nm environ du substrat 10 et le diamètre local au niveau de la boîte quantique 24 étant de 200nm environ. Le diamètre local présente une variation longitudinale monotone et sensiblement linéaire avec un angle d'inclinaison α de la bordure latérale sensiblement constant suivant l'axe Z et compris entre 3° et 5° environ.

En variante, dans le cas où le cœur 21 du fil photonique 20 présente une forme effilée (fig.6), le cœur 21 du fil photonique 20 peut présenter une hauteur de l'ordre de 10µm, voire moins, un diamètre minimal dₘᵢₙ de 150nm environ à l'extrémité supérieure 21.2, une diminution monotone et linéaire du diamètre local suivant la direction -Z avec un angle d'inclinaison de l'ordre de 1° à 2° environ sur une hauteur de 1µm environ, puis un diamètre local sensiblement constant et égal à 200nm environ jusqu'à l'extrémité inférieure 21.1 du cœur 21 du fil photonique 20.

Cependant, un tel émetteur 24 de paires de photons peut présenter une séparation en énergie S non nulle entre les niveaux d'énergie des états excitoniques Xₓ et X_{y}, c'est-à-dire une séparation en énergie S supérieure à la largeur des raies d'émission associées aux transitions excitoniques.

Pour réduire cette séparation en énergie S jusqu'à au moins une valeur inférieure à la largeur des raies d'émission excitoniques, et ainsi améliorer le degré d'intrication en polarisation de la paire de photons, une idée peut consister à faire subir à la boîte quantique 24 des contraintes mécaniques adaptées, comme indiqué dans l'article de Trotta et al. 2015, c'est-à-dire orientées suivant les axes optiques x et y des dipôles optiques associés aux transitions excitoniques Xₓ et X_{y}. Dans ce cas, on peut chercher à déformer le fil photonique 20 dans le plan XY, celui-ci étant alors formé du seul cœur 21 en GaAs sans la gaine 25 décrite plus loin, suivant un axe de déformation Ad de préférence aligné avec l'axe optique x ou l'axe optique y.

Cependant, comme le montre l'article de Yeo et al. intitulé Strain-mediated coupling in a quantum dot-mechanical oscillator hybrid system, Nat. Nanotechnol. 9, 106-110 (2014), la déformation du fil photonique 20 (ici le déplacement de l'extrémité supérieure dans le plan XY) conduit à l'apparition d'un plan Pn_{c} neutre en déformation dans la section droite où est située la boîte quantique 24, ce plan neutre Pn_{c} étant orienté de manière orthogonale à l'axe de déformation Ad et passant par l'axe principal Δ. C'est le cas lorsque le cœur 21 présente un haut degré de symétrie de rotation autour de l'axe principal Δ.

Aussi, dans le cas où la boîte quantique est située sur l'axe principal Δ, la déformation d'un fil photonique 20 formé du seul cœur 21 tel que décrit précédemment ne permet pas d'appliquer une contrainte mécanique non nulle à la boîte quantique 24, de sorte que la séparation en énergie S n'est alors pas réduite. La contrainte mécanique dont il s'agit ici est une contrainte mécanique appliquée de manière ajustable par un dispositif de déformation du fil photonique. Il s'agit donc une contrainte mécanique (additionnelle) qui s'ajoute à une éventuelle contrainte mécanique que peut subir la boîte quantique à la suite de sa réalisation.

Une autre idée peut alors consister à déplacer la boîte quantique 24 dans le plan XY de manière orthogonale à ce plan neutre Pn_{c}, et à déformer le fil photonique 20 comme dans l'article de Yeo et al. 2014 (déplacement de l'extrémité supérieure du fil photonique 20 dans le plan XY suivant un axe de déformation orienté ici suivant l'axe X).

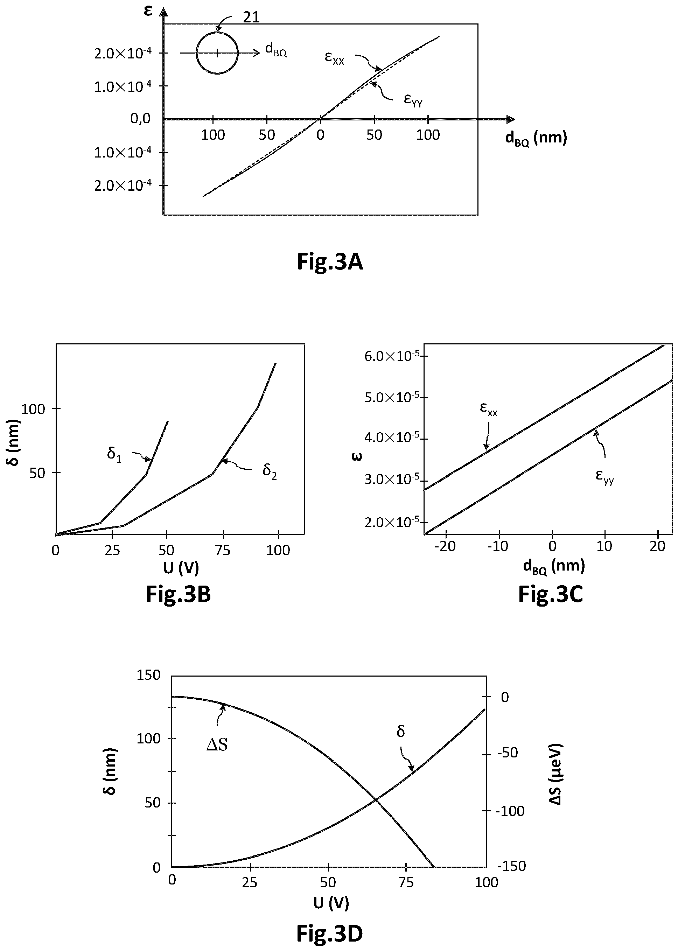

À ce titre, la figure 3A illustre un exemple d'évolution des déformations ε_{XX} et ε_{YY} associées au tenseur de déformation de la boîte quantique 24 en fonction de la distance d_{BQ} de celle-ci vis-à-vis du plan neutre Pn_{c}. Ici, le plan neutre Pn_{c} passe par l'axe Y et la distance d_{BQ} est mesurée à partir de l'axe principal Δ suivant l'axe X. La déformation ε_{XX} est donc orientée suivant l'axe X du repère XYZ, et la déformation ε_{YY} est orientée suivant l'axe Y. Les axes X et Y du repère XYZ (et donc les déformations ε_{XX} et ε_{YY}) sont ici préférentiellement alignés suivant les axes optiques x et y des dipôles optiques associés aux transitions excitoniques.

Dans cet exemple, l'extrémité supérieure 21.2 du fil photonique 20 subit un déplacement δ de 80nm environ suivant l'axe X. Le fil photonique 20 est formé du seul cœur 21 en GaAs dont la section droite le long de l'axe principal Δ est circulaire. Il présente une hauteur de 20µm environ. La boîte quantique 24 est de l'InAs située à une distance de 100nm environ du substrat 10, et le diamètre local du fil photonique 20 dans la section droite où se trouve la boîte quantique 24 est de l'ordre de 200nm.

Comme l'illustre la fig.3A, les déformations ε_{XX} et ε_{YY} du tenseur de contraintes associée à la boîte quantique 24 sont nulles lorsque celle-ci est située sur l'axe principal Δ et donc dans le plan neutre Pn_{c}. Le positionnement d_{BQ} de la boîte quantique 24 suivant l'axe X conduit à rendre non nulle la déformation ε_{XX}, mais également la déformation ε_{YY}. Or, il apparaît que les valeurs des déformations ε_{XX} et ε_{YY} évoluent de manière identique, de sorte que l'écart ε_{XX} - ε_{YY} reste sensiblement nul quel que soit le décalage d_{BQ} de la boîte quantique 24 suivant un axe orthogonal au plan neutre Pn_{c}.

Or, Trotta et al. 2015 a montré que la séparation en énergie S est proportionnelle à l'écart ε_{XX} - ε_{YY}, de sorte que le décalage d_{BQ} de la boîte quantique 24 vis-à-vis du plan neutre Pn_{c}, pour un fil photonique 20 formé du seul cœur 21 décrit précédemment sans la gaine 25 selon l'invention, ne permet pas de réduire la séparation en énergie S. En revanche, l'énergie de bande interdite de la boîte quantique 24 est modifiée, comme l'a montré l'article de Yeo et al. 2014.

Aussi, pour améliorer le degré d'intrication associé à la paire de photons émis par la source de lumière 1, on réalise un fil photonique 20 qui présente un caractère sensiblement isotrope d'un point de vue optique et un caractère anisotrope d'un point de vue mécanique. Plus précisément, le fil photonique 20 comporte :
- un cœur 21 formant un guide d'onde monomode dont le mode optique guidé est dégénéré en polarisation, et donc présentant un degré de symétrie de rotation d'ordre 4 autour de l'axe principal Δ, c'est-à-dire un degré de symétrie d'ordre 4, 8, 12, etc... ou une symétrie axiale ;
- une gaine 25 de bas indice de réfraction, qui revêt au moins partiellement le cœur 21, et s'étend dans un plan XY parallèle au substrat 10 suivant un axe transversal principal At_{g}, de sorte que la gaine 25 présente une asymétrie de révolution vis-à-vis de l'axe principal Δ (ou asymétrie axiale), et donc que le fil photonique 20 formé du cœur 21 et de la gaine 25 présente des propriétés mécaniques anisotropes dans le plan XY.

À cette configuration structurelle particulière du fil photonique 20, on associe un dispositif de correction 50, adapté à induire par effet électrostatique une déformation mécanique du fil photonique 20 dans un plan XY parallèle au substrat 10, suivant un axe de déformation Ad qui forme un angle d'inclinaison, dans le plan XY, compris entre 0° et 90°, ces valeurs étant exclues, vis-à-vis de l'axe transversal principal At_{g} de la gaine 25. L'émetteur 24 subit alors des contraintes mécaniques telles que la séparation en énergie S peut être ajustée et réduite de manière contrôlée, permettant ainsi de maximiser le degré d'intrication en polarisation de la paire de photons.

De préférence, cet angle d'inclinaison entre Ad et At_{g} est compris entre 20° et 70° environ, et est avantageusement compris entre 30° et 40° environ, améliorant ainsi l'efficacité de correction et modification de la valeur de la séparation en énergie S. Par ailleurs, l'axe de déformation Ad est de préférence orienté suivant l'axe optique x ou suivant l'axe optique y des dipôles optiques dₓ, d_{y} associés aux transitions excitoniques, de manière à améliorer également l'efficacité de correction et modification de la valeur de la séparation S.

Le fil photonique 20 comporte une gaine 25 qui revêt au moins une partie de la bordure latérale du cœur 21 dans un plan XY. Elle s'étend dans le plan XY suivant un axe transversal principal At_{g}, c'est-à-dire qu'elle présente une dimension radiale (orthogonale à l'axe principal Δ) maximale dans le plan XY, à partir du cœur 21, qui définit l'axe transversal principal At_{g}. Autrement dit, la gaine 25 présente, dans le plan XY, une longueur orientée suivant l'axe transversal principal At_{g}, et une largeur orientée suivant un axe orthogonal à l'axe At_{g}, la longueur étant supérieure à la largeur. Cet axe transversal principal At_{g} est sécant et orthogonal à l'axe principal Δ et passe par le point de la gaine 25 de dimension radiale maximale dans le plan XY. Cet axe transversal principal At_{g} est de préférence identique quelle que soit la hauteur du fil photonique 20.

Aussi, la gaine 25 présente une asymétrie de révolution vis-à-vis de l'axe principal Δ, c'est-à-dire qu'elle présente une forme non cylindrique de révolution autour de Δ. On peut également qualifier la gaine 25 d'asymétrique axiale autour de Δ, les notions de symétrie axiale et de symétrie de révolution étant ici identiques.

Aussi, le fait que la gaine 25 présente une asymétrie de révolution vis-à-vis de l'axe principal Δ, du fait de son axe transversal principal At_{g}, rend les propriétés mécaniques du fil photonique 20 anisotropes dans le plan XY, alors que les propriétés optiques du cœur 21 seul sont sensiblement isotropes dans le plan XY du fait que le cœur 21 présente un ordre élevé (égal à 4) de symétrie de rotation autour de l'axe principal Δ. Le caractère sensiblement isotrope des propriétés optiques du cœur 21 est à entendre ici au sens d'une symétrie de rotation d'ordre 4 autour de l'axe principal Δ. Aussi, le cœur 21 présente les mêmes propriétés optiques pour le dipôle optique dₓ que pour le dipôle optique d_{y}, lesquels sont orthogonaux entre eux. De plus, le fait que la gaine 25 présente un indice de réfraction faible permet de ne pas modifier les propriétés optiques associées au cœur 21, de sorte que les propriétés optiques du fil photonique 20 sont sensiblement isotropes dans le plan XY.

La gaine 25 s'étend de préférence sur toute la hauteur du fil photonique 20. Elle peut revêtir entièrement ou partiellement le cœur 21 dans le plan XY. La dimension radiale maximale de la gaine 25 à partir du cœur 21 peut être constante suivant l'axe Z, notamment dans le cas où elle est réalisée par dépôt PVD assisté par faisceau d'électrons (EBPVD) sous incidence rasante suivant l'axe transversal principal At_{g}. Par incidence rasante, on entend que le matériau de la gaine 25 est déposé suivant une direction de dépôt parallèle à l'axe transversal principal At_{g} et formant un angle d'inclinaison vis-à-vis du plan XY inférieur à 90° et de préférence inférieur ou égal à 20°. En variante, comme décrit plus loin (cf. fig.7), elle peut présenter une dimension radiale maximale à partir du cœur 21 qui augmente à mesure que l'on se rapproche du substrat 10, notamment dans le cas où elle est réalisée par lithographie et gravure d'une couche diélectrique d'encapsulation du cœur 21.

La gaine 25 du fil photonique 20 est réalisée à base d'un matériau de bas indice de réfraction n_{g}, c'est-à-dire d'un indice de réfraction inférieur à l'indice n_{c} du cœur 21, ici en un oxyde de silicium d'indice n_{g} égal à 1.5, ou en un nitrure de silicium, un oxyde d'aluminium, ou équivalent. Ainsi, du fait du fort écart entre l'indice n_{c} du cœur 21 et celui n_{g} de la gaine 25, le mode guidé reste fortement confiné dans le cœur 21 du fil photonique 20. Les propriétés optiques du fil photonique 20 restent donc essentiellement définies par le cœur 21 et ne sont pas perturbées par la présence de la gaine 25 et son asymétrie de révolution.

À titre d'exemple, dans le cas d'un dépôt de 200nm de SiO₂ par EBPVD sous incidence rasante, et pour un cœur 21 de forme circulaire et de diamètre de 200nm dans le plan de la boîte quantique 24, la gaine 25 présente localement une forme oblongue de 400nm de longueur (dimension maximale) suivant l'axe transversal principal At_{g} et de 200nm de largeur.

Le dispositif de correction 50 est adapté à induire par effet électrostatique une déformation mécanique du fil photonique 20 dans un plan XY parallèle au substrat 10, suivant un axe de déformation Ad formant un angle d'inclinaison vis-à-vis de l'axe transversal de la gaine 25 compris entre 0° et 90°, ces valeurs étant exclues, de préférence compris entre 20° et 70°, et avantageusement compris entre 30° et 40°.

L'émetteur 24 subit alors des contraintes mécaniques telles que la séparation en énergie S peut être ajustée et réduite de manière contrôlée, permettant ainsi de maximiser l'intrication en polarisation de la paire de photons émis. Cet axe de déformation Ad est de préférence aligné avec l'un des axes optiques x, y des dipôles optiques dₓ et d_{y} associés aux transitions excitoniques. Dans cet exemple, l'axe de déformation Ad est orienté suivant l'axe optique x du dipôle dₓ, lequel est orienté suivant l'axe X du repère XYZ (cf. fig. 2B). La déformation ε_{XX} est orientée suivant l'axe X de la fig.2B, et la déformation ε_{YY} est orientée suivant l'axe Y.

Pour cela, le dispositif de correction 50 comporte au moins deux électrodes 51 adaptées à générer un champ électrique non uniforme, et ainsi à générer une force électrostatique appliquée au fil photonique 20 conduisant à la déformation mécanique de celui-ci dans le plan XY.

Les électrodes 51 sont agencées de part et d'autre du fil photonique 20 dans le plan XY et sont disposées vis-à-vis du fil photonique 20 de sorte que celui-ci présente une distance Dₚ, à l'une 51p des électrodes 51, inférieure à la distance D_{d} à l'autre électrode 51d. On appelle électrode proximale 51p l'électrode la plus proche du fil photonique 20, et électrode distale 51d l'électrode la plus éloignée.

L'axe de déformation Ad, qui correspond à l'orientation de la force électrostatique appliquée au fil photonique 20 par le champ électrique non uniforme, passe en première approximation par une extrémité orientée vers le fil photonique 20 de l'électrode proximale 51p et par l'axe principal Δ.

De préférence, au moins l'électrode proximale 51p (et ici les deux électrodes 51) présente une forme en pointe dans le plan XY, la pointe étant orientée vers le fil photonique 20. Un champ électrique non uniforme peut alors être généré. Les électrodes 51 sont réalisées en un matériau électriquement conducteur, par exemple de l'or d'une épaisseur de 200nm environ.

Les électrodes 51 sont disposées à une surface supérieure plane de piliers 53 qui reposent sur le substrat 10. Les piliers 53 présentent une hauteur de préférence sensiblement égale à celle du fil photonique 20, et sont réalisés à base du même matériau cristallin que celui du cœur 21 du fil photonique 20, à savoir ici du GaAs. Ils présentent un diamètre local au contact du substrat 10 de préférence au moins égal à plusieurs centaines de nanomètres, par exemple supérieur ou égal à 2µm ou davantage. Les piliers 53 présentent une surface supérieure suivant l'axe Z sensiblement plane. Elle peut comporter une portion de couche antireflet 26. Aussi, les électrodes 51 sont sensiblement coplanaires à l'extrémité supérieure du fil photonique 20, à la couche antireflet 26 près. Cette couche antireflet 26 peut assurer une fonction d'isolation électrique entre les électrodes 51 et les piliers 53.

Par ailleurs, le dispositif de correction 50 comporte une source de tension électrique, connectée aux électrodes 51, adaptée à appliquer une tension électrique continue U dont la valeur est prédéfinie de sorte que l'intrication en polarisation des photons émis est obtenue. Cette valeur est de préférence déterminée lors d'une étape préalable de calibration. La source de tension peut être connectée aux électrodes 51 par des fils électriques, de type nanofils d'or ou de carbone.

Aussi, en fonctionnement, le dispositif de correction 50 applique une tension électrique continue U aux électrodes 51 d'une valeur prédéfinie. Les électrodes 51 génèrent alors un champ électrique non uniforme au sein duquel est situé le fil photonique 20. Le fil photonique 20 se polarise alors, ce qui se traduit par la formation d'une force électrostatique orientée en direction de l'électrode proximale 51p. Le fil photonique 20 se déforme alors sous l'effet de cette force électrostatique suivant l'axe de déformation Ad. Plus précisément, l'extrémité supérieure du fil photonique 20 subit un déplacement δ non nul en direction de l'électrode proximale 51p suivant l'axe de déformation Ad.

Ce déplacement δ génère un champ de contrainte mécanique à déformations ε_{XX} et ε_{YY} dans la boîte quantique 24. Du fait que l'axe transversal principal At_{g} de la gaine 25 est incliné vis-à-vis de l'axe de déformation Ad du fil photonique 20 (lequel est sensiblement colinéaire à l'orientation de la force électrostatique), le tenseur de contrainte associé à la boîte quantique 24 se traduit par des déformations ε_{XX} et ε_{YY} dont l'écart est alors non nul, la valeur de cet écart étant corrélée à l'intensité de la tension électrique U appliquée. Cet écart ε_{XX} - ε_{YY} non nul permet ainsi d'ajuster et de réduire voire annuler la séparation en énergie S de l'émetteur 24, améliorant ainsi le degré en intrication de la paire de photons.

Comme indiqué précédemment, la déformation ε_{XX} est orientée suivant l'axe de déformation Ad (et ici suivant l'axe X), et la déformation ε_{YY} est orientée de manière orthogonale à l'axe de déformation Ad. Ces déformations ε_{XX} et ε_{YY} sont parallèles au plan XY. La déformation ε_{XX} est ici avantageusement orientée suivant l'axe optique x du dipôle optique dₓ associé aux transitions excitoniques Xₓ, et la déformation ε_{YY} est alors orientée suivant l'axe optique y du dipôle optique d_{y} associé aux transitions excitoniques X_{y}, améliorant ainsi l'efficacité de modification de la valeur de la séparation en énergie S.

La figure 3B illustre un exemple d'évolution du déplacement δ du fil photonique 20 dans le plan XY, et plus précisément du déplacement de l'extrémité supérieure 21.2, en fonction de la tension électrique U appliquée, dans les cas où le fil photonique 20 comporte (δ₂) ou non (δ₁) la gaine 25 à asymétrie de révolution décrite précédemment.

Dans cet exemple, le fil photonique 20 comporte un cœur 21 en GaAs à section droite circulaire, de 200nm de diamètre au contact avec le substrat 10, et de 3.5µm de diamètre au sommet, et de 20µm de hauteur. Une boîte quantique 24 d'InAs est placée sensiblement sur l'axe principal Δ, à une hauteur de 100nm au-dessus de la couche réflectrice 12. Le fil photonique 20 comporte ou non une gaine 25 réalisée en SiO₂, déposé par PVD directionnel autour du cœur 21 suivant l'axe transversal principal At_{g}, de forme oblongue de longueur (dimension maximale) de 400nm et de largeur de 200nm.

Les deux électrodes 51 en pointe sont espacées l'une de l'autre d'une distance de 4760nm (distance à partir des pointes), et, en l'absence de déplacement du fil photonique 20, le centre du cœur 21 est situé à une distance de 2040nm de l'électrode proximale et de 2720nm de l'électrode distale.

Il en ressort que le déplacement δ augmente fortement avec l'augmentation de la tension électrique U. Ainsi, en l'absence de la gaine 25 (δ₁), le fil photonique 20 (cœur 21 en GaAs seul) se déplace d'une valeur de 80nm environ suivant l'axe de déformation Ad pour une valeur de 50V environ. En revanche, en présence de la gaine 25 (δ₂), le fil photonique 20 se déplace de la même valeur de 80nm pour une tension électrique de 85V environ, signe que la gaine 25 à asymétrie de révolution induit une modification du comportement mécanique du fil photonique 20.

La figure 3C illustre un exemple d'évolution des déformations ε_{XX} et ε_{YY} associées au tenseur des contraintes de la boîte quantique 24 en fonction de la position d_{BQ} de celle-ci dans le plan XY à partir de l'axe principal Δ (d_{BQ}=0). Le fil photonique 20 et les électrodes 51 sont dimensionnés de manière identique à l'exemple de la fig.3B. Le fil photonique 20 est déformé par effet électrostatique du fait d'une tension électrique U non nulle, ici égale à 70V.

Il apparaît que les déformations ε_{XX} et ε_{YY} sont non nulles, que la boîte quantique 24 soit disposée sur l'axe principal Δ ou qu'elle en soit éloignée. De plus, l'écart entre ces déformations ε_{XX} et ε_{YY} est non nul et prend ici une valeur de 10⁻⁵, laquelle peut être suffisante pour annuler la séparation en énergie S de la boîte quantique 24 et ainsi participer à maximiser le degré d'intrication de la paire de photons émis. Il est donc possible de réduire la séparation en énergie S associée à la boîte quantique 24 alors même que celle-ci est placée sur l'axe principal Δ. Ce positionnement sur l'axe principal Δ, à 20 nm près, contribue d'ailleurs à améliorer le degré d'intrication de la paire de photons en rendant sensiblement identique la durée de vie des excitons Xₓ et X_{y}.

La figure 3D illustre un exemple d'évolution du déplacement δ de l'extrémité supérieure du fil photonique 20 dans le plan XY et suivant l'axe de déformation Ad en fonction de la tension électrique U, et illustre également l'évolution d'un écart ΔS de la séparation en énergie S de la boîte quantique 24 vis-à-vis de sa valeur initiale S₀ (hors contrainte). Le fil photonique 20 et les électrodes 51 sont dimensionnés de manière identique à l'exemple des fig.3A et 3B. Dans cet exemple, la boîte quantique 24 présente une valeur S₀ de 50µeV. L'évolution de l'écart ΔS de la séparation en énergie S à la valeur initiale S₀ en fonction de la tension électrique appliquée a été obtenue ici en simulant le déplacement du sommet du fil et le champ de déformation qu'il induit à la base du fil photonique à l'aide du logiciel COMSOL Multiphysics, et en appliquant le formalisme développé dans l'article de Trotta et al. 2015 pour en déduire l'évolution de la séparation en énergie S. Cependant, en cours de calibration ou d'utilisation de la source, l'évolution de la séparation en énergie S peut être obtenue simplement en mesurant (par spectroscopie de luminescence) l'énergie des photons associés aux transitions excitoniques Xₓ et X_{y} vers l'état fondamental G en fonction de la tension U. La séparation en énergie S est approximativement annulée lorsque les pics d'énergie associés à ces photons ne peuvent être séparés dans le spectre de luminescence.

Il apparaît que pour une tension allant de 0V à 100V, la force électrostatique induit un déplacement δ dans le plan XY du fil photonique 20 allant de 0nm à 125nm environ suivant l'axe de déformation Ad. Les valeurs des déformations ε_{XX} et ε_{YY} subies par la boîte quantique 24, et plus précisément l'écart (ε_{XX} - ε_{YY}) entre les déformations ε_{XX} et ε_{YY}, permettent de faire varier la séparation en énergie S. Elle présente ici une valeur de 50µeV pour une tension nulle (et une contrainte appliquée nulle), diminue à mesure qu'augmente la tension électrique jusqu'à s'annuler pour une tension électrique de 48V environ, puis augmente jusqu'à 100µeV pour une tension électrique de 100V environ. Aussi, pour l'application d'une tension de 48V environ, la séparation en énergie S s'annule, de sorte que l'intrication totale de la paire de photons émis est alors obtenue (la boîte quantique 24 étant située sur l'axe principal Δ).

Aussi, la source de lumière 1 selon l'invention permet d'ajuster de manière contrôlée la valeur de la séparation en énergie S de l'émetteur 24, ici de la boîte quantique 24 (à mieux que la largeur des raies d'émission près), et ainsi de la réduire jusqu'à l'annuler dans le but de maximiser le degré d'intrication en polarisation de la paire de photons émis. Comme décrit précédemment, ceci est obtenu par l'association entre, d'une part l'anisotropie des propriétés mécaniques du fil photonique 20 du fait de la gaine 25 à asymétrie de révolution du fait de l'axe transversal principal At_{g}, sans que les propriétés optiques du fil photonique 20 (définies par les propriétés du cœur 21) ne soient modifiées par la gaine 25, et d'autre part la déformation du fil photonique 20 par effet électrostatique suivant un axe de déformation Ad incliné vis-à-vis de l'axe transversal principal At_{d}. Par ailleurs, l'émetteur 24 est avantageusement situé sur l'axe principal Δ, de sorte que les durées de vie des excitons Xₓ et X_{y} sont sensiblement égales, permettant de maximiser également le degré d'intrication de la paire de photons.

La source de lumière 1 comporte un dispositif d'excitation optique 30 adapté à provoquer l'émission spontanée d'une paire de photons par la boîte quantique 24 en réponse à un signal d'excitation (ici une impulsion laser), et comporte de préférence un dispositif de collection 40 adapté à collecter le signal émis (paire de photons) par l'émetteur 24 en réponse à l'impulsion laser d'excitation et extrait hors du fil photonique 20 suivant la direction +Z.

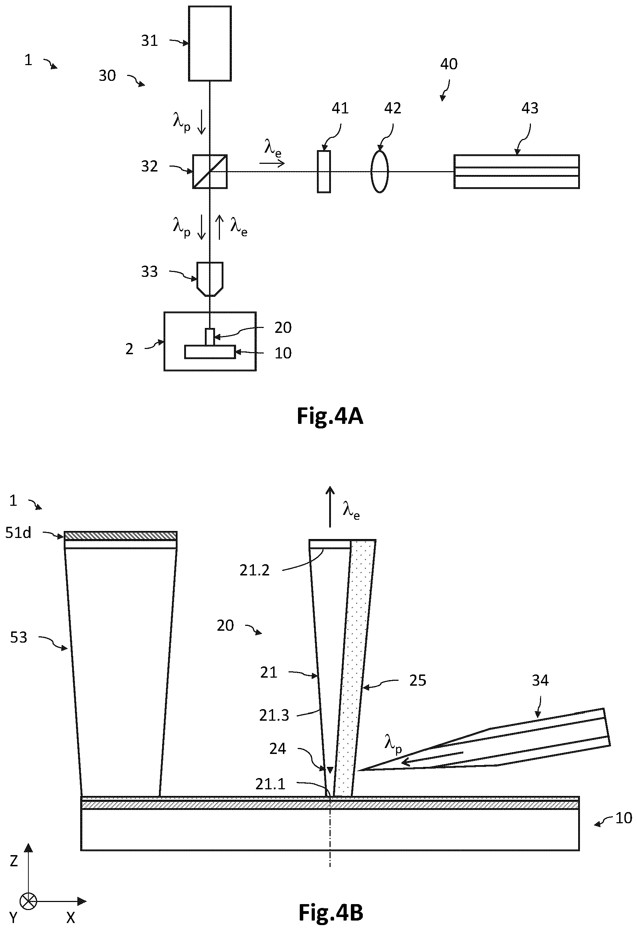

La figure 4A illustre de manière partielle et schématique un exemple du dispositif d'excitation optique 30 et du dispositif de collection 40, pour laquelle le chemin optique d'excitation et le chemin optique de collection sont en partie confondus.

Le dispositif d'excitation optique 30 comporte une source laser 31 adaptée à émettre un signal dit d'excitation, ou de pompage, (impulsion laser) à une longueur d'onde d'excitation λₚ (ou de pompage) permettant la formation de deux paires électron-trou dans l'émetteur 24. De façon privilégiée, l'énergie d'un photon laser sera égale à la moitié de la différence d'énergie entre l'état biexcitonique XX et l'état fondamental G de l'émetteur, pour permettre une préparation de l'état XX par exemple par la technique connue d'absorption non linéaire à deux photons. Cette manière privilégiée permet notamment d'obtenir une grande finesse spectrale des raies excitoniques, propriété importante lorsqu'on souhaite que les paires de photons soient à la fois enchevêtrées et indiscernables. Il est cependant aussi possible de générer à la demande des paires de photons enchevêtrés en utilisant un laser dont l'énergie par photon est supérieure à la bande interdite de la couche de mouillage (par exemple λₚ =840 nm pour des boîtes quantiques d'InAs dans GaAs), ou du matériau constituant la barrière de la boîte quantique (par exemple λₚ =810 nm pour GaAs). La source laser peut être un laser titane-saphir dont la longueur d'onde λₚ est par exemple accordable dans la gamme 1000nm -750nm. La cadence de répétition peut être de 80 MHz environ voire davantage (quelques GHz), et la largeur typique des impulsions laser peut être de l'ordre de la picoseconde, voire moins.

Dans cet exemple, le chemin optique des impulsions laser est défini par des optiques non représentées de telle sorte que le signal d'excitation soit incident sur le cœur 21 du fil photonique 20 de manière colinéaire avec l'axe principal Δ. Le signal d'excitation traverse une lame semi-réfléchissante 32, puis un microscope confocal 33 qui focalise le signal d'excitation sur le cœur 21 du fil photonique 20.

Pour que l'émetteur 24 présente une émission spectralement fine, le fil photonique 20 et le substrat 10 sont de préférence disposés dans un cryostat 2 de manière à porter la température à une valeur de préférence inférieure à quelques dizaines de kelvins.

Les photons émis sont extraits hors du fil photonique 20 suivant l'axe principal Δ au travers de l'extrémité supérieure 21.2, et orientés suivant la direction +Z, puis transmis par le microscope confocal 33, réfléchis par la lame semi-réfléchissante 32, et sont collectés par le dispositif de collection 40 qui assure ici un couplage optique entre le fil photonique 20 et ici un guide d'onde externe 43.

Sur le chemin optique de collection, en aval de la lame semi-réfléchissante 32, le dispositif de collection 40 comporte avantageusement au moins un filtre spectral 41 pour filtrer le signal d'excitation, et notamment dans le cas où le fil photonique 20 comporte plusieurs boîtes quantiques 24 situées dans la même couche de mouillage. Le filtre spectral 41 peut comporter un réseau de diffraction et présenter une résolution de 0.1nm par exemple. Ainsi, le filtre spectral 41 permet de sélectionner les photons associés aux différentes transitions excitoniques, et de filtrer le signal d'excitation. Il est également possible d'identifier une boîte quantique 24 particulière, de préférence celle disposée le plus près de l'axe longitudinal. En effet, une telle boîte quantique 24 présente un taux d'émission spontanée (*spontaneous emission rate,* en anglais) élevé, comme l'indique notamment l'article de Claudon et al. intitulé A highly efficient single-photon source based on a quantum dot in a photonic nanowire, Nat. Photonics 4, 174 (2010).

Le dispositif de collection 40 comporte ici une lentille 42 permettant de focaliser le signal émis sur l'entrée d'un guide d'onde externe 43, par exemple une fibre optique. La fibre optique 43 peut ensuite être reliée à un photodétecteur, par exemple à avalanche, ou à tout autre dispositif optique et/ou électronique en fonction de l'application souhaitée de la source de lumière 1.

Cependant, il peut être avantageux de dissocier entièrement le chemin optique du signal d'excitation du chemin optique du signal émis par le fil photonique 20.

À ce titre, la figure 4B illustre de manière partielle et schématique un autre exemple du dispositif d'excitation optique 30 et du dispositif de collection 40, pour lequel le chemin optique d'excitation et le chemin optique de collection sont entièrement dissociés.

Le dispositif d'excitation optique 30 comporte ainsi un guide d'onde 34 couplé à la source laser 31 et dont l'extrémité d'émission est disposée à proximité et en direction de l'émetteur 24 du fil photonique 20, suivant un angle non nul vis-à-vis de l'axe principal Δ, par exemple un angle supérieur ou égal à 45° et avantageusement proche de 90°. Aussi, le signal d'excitation (impulsion laser) est transmis en direction de la boîte quantique 24 par la bordure latérale 21.3 du cœur 21 du fil photonique 20, et non pas par l'extrémité supérieure 21.2 et de manière colinéaire à l'axe principal Δ. Dans l'exemple de la fig.4B, le guide d'onde 34 est une fibre optique dont l'extrémité est effilée (ses dimensions transversales diminuent en direction de son extrémité d'émission). Une telle fibre optique (*tapered optical fiber,* en anglais) peut être placée au voisinage du fil photonique 20 par un micromanipulateur à une fraction de micron près, puis solidarisée au substrat 10 au moyen par exemple d'un matériau adhésif (colle).

Le dispositif de collection 40 peut alors être similaire à celui illustré sur la fig.4A. Cette configuration réduit fortement la probabilité que le dispositif de collection 40 puisse collecter une partie du signal d'excitation diffusée par le fil photonique 20. En utilisant de plus la technique d'excitation résonante à deux photons pour exciter sélectivement une seule boîte quantique, on peut alors enlever le filtre spectral 41, et écarter les pertes optiques qu'il induit. On optimise ainsi l'efficacité de la source de lumière 1.

Notons par ailleurs que la source de lumière 1 garde les caractéristiques avantageuses propres aux fils photoniques monomodes à adaptateur de mode. Le fil photonique 20 présente un diagramme d'émission à faible ouverture numérique, ce qui permet un couplage efficace à un guide d'onde externe. Par ailleurs, il est possible de réaliser une source de lumière 1 accordable en longueur d'onde, en appliquant à la portion inférieure du cœur 21 du fil photonique 20 un champ externe (par ex. champ électrique ou un champ de contrainte mécanique généré par un actuateur piézoélectrique) modifiant l'énergie de bande interdite de la boîte quantique 24 semiconductrice, sans que cela affecte le degré d'intrication de la source de lumière 1.

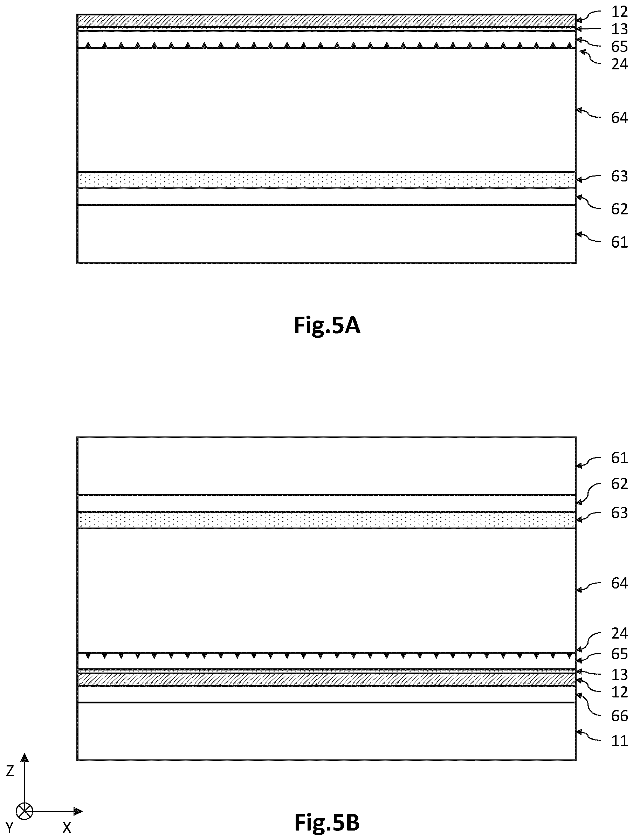

Un exemple de procédé de fabrication de la source de lumière 1 selon un mode de réalisation est maintenant décrit en référence aux figures 5A à 5F qui illustrent différentes étapes du procédé.

Lors d'une première étape (fig.5A), on réalise un empilement de couches épitaxiées à partir d'un premier substrat 61. Le premier substrat 61 est de préférence réalisé en un matériau cristallin présentant une faible différence du paramètre de maille avec le matériau cristallin principal du fil photonique 20. Dans cet exemple, le premier substrat 61 est réalisé en GaAs. L'épitaxie des couches en question peut être une épitaxie par jets moléculaires (MBE, pour *Molecular Beam Epitaxy,* en anglais) ou une épitaxie en phase vapeur aux organométalliques (MOCVD pour *MetalOrganic Chemical Vapor Deposition,* en anglais), ou toute autre technique d'épitaxie équivalente.

L'empilement est formé des couches suivantes, disposées les unes sur les autres à partir du premier substrat 61 :
- une couche 62, dite couche tampon, en GaAs de 500nm d'épaisseur environ, déposée au contact du premier substrat 61 ;
- une couche sacrificielle 63, par exemple réalisée à base de AlAs, ici de l'Al₁₋ₓGaₓAs pauvre en gallium (x_{Ga} inférieur ou égal à 0.4), de 500nm d'épaisseur environ ;
- une couche 64 en le matériau cristallin de haut indice du fil photonique 20, ici en GaAs, d'une épaisseur correspondant à la hauteur h₂ souhaitée de la partie supérieure, par exemple 12µm environ ;
- une couche active, formée d'une couche de mouillage d'une épaisseur de 0.5nm réalisée en le composé semiconducteur formant les boîtes quantiques, par exemple en InAs, et des boîtes quantiques 24 (seules les boîtes quantiques sont représentées, ici par des triangles) ;
- une couche 65 en le matériau cristallin de haut indice, ici en GaAs, destinée à former la partie inférieure, par exemple d'une épaisseur de 100nm environ.

La couche active est réalisée selon les connaissances techniques de l'homme du métier, selon par exemple les conditions décrites dans l'article de Gérard et al. intitulé Optical investigation of the self-organized growth of InAs/GaAs quantum boxes, J. Crystal Growth 150, 351 (1995). Elle peut présenter une épaisseur de l'ordre de 0.5nm et comporter des boîtes quantiques disposées dans le plan XY avec une densité surfacique par exemple égale à 200 boîtes quantiques par micron.

On réalise ensuite la couche réflectrice 12 à partir de la face libre de l'empilement. L'empilement est pour cela revêtu d'une couche diélectrique 13, réalisée en un matériau diélectrique d'une part, et inerte à un agent de gravure utilisé ultérieurement lors d'une étape de réalisation du fil photonique 20 et des piliers 53. La couche diélectrique 13 peut être un nitrure de silicium, par exemple du S₁₃N₄ d'une épaisseur de 10nm environ. La couche diélectrique 13 est ensuite revêtue d'une couche réflectrice 12 à la longueur d'onde des photons émis par la source de lumière 1. La couche réflectrice 12 peut être réalisée en un matériau métallique tel que de l'or d'une épaisseur de 100nm à 300nm environ.

Lors d'une étape suivante (fig.5B), on solidarise l'empilement à un deuxième substrat 11. Pour cela, on met en contact la face libre de la couche réflectrice 12 avec une couche adhésive 66 réalisée en un matériau adhésif qui revêt un deuxième substrat 11. Celui-ci peut être réalisé en un matériau cristallin éventuellement semiconducteur, par exemple du GaAs dopé ou non. La couche adhésive 66 peut être réalisée en une colle époxy, ou en un polymère tel qu'une résine pour lithographie optique. Toute autre technique de solidarisation peut être utilisée. Le substrat 10 sur lequel est destiné à reposer le fil photonique 20 est alors formé du deuxième substrat 11, de la couche adhésive 66, de la couche réflectrice 12, et de la couche diélectrique 13.

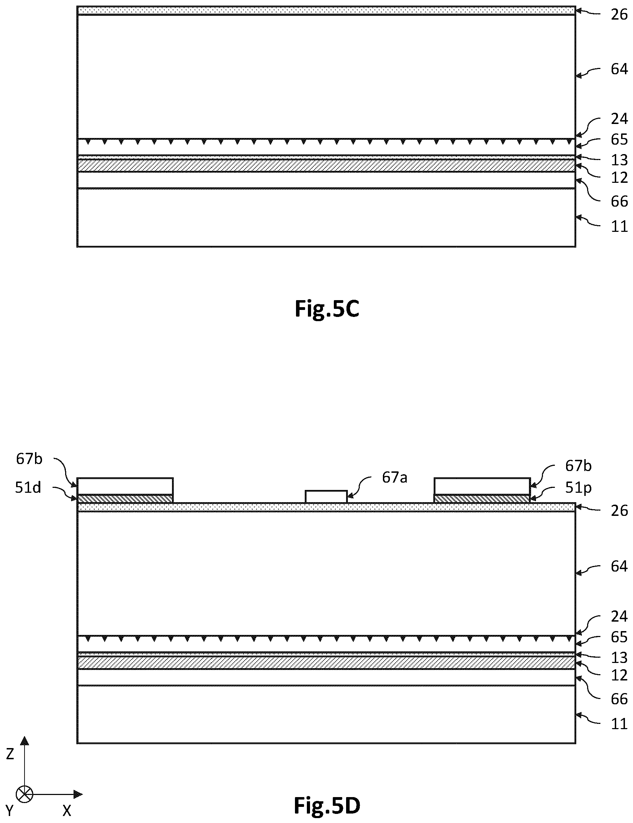

Lors d'une étape suivante (fig.5C), on réalise un amincissement de l'empilement de manière à rendre libre une face de la couche 64 en GaAs. Pour cela, on réalise par exemple un amincissement du premier substrat 61 par polissage mécanique ou mécano-chimique jusqu'à conserver une épaisseur de GaAs comprise entre 50µm et 100µm environ. On réalise ensuite une gravure chimique du premier substrat 61 aminci et de la couche tampon 62 par un agent de gravure sélectif vis-à-vis de la couche sacrificielle 63. On réalise enfin une gravure chimique de la couche sacrificielle 63 par un agent de gravure sélectif vis-à-vis du matériau cristallin principal, par exemple par gravure HF (acide fluorhydrique). On obtient ainsi une face libre de la couche 64 en GaAs de bonnes propriétés optiques (faibles rugosités), minimisant ainsi les éventuelles pertes optiques au niveau de cette face.

Ensuite, on dépose une couche antireflet 26 sur la face libre de la couche 64 en GaAs. Cette couche antireflet 26 a un indice de réfraction nₐᵣ , lequel est proche de √n (n étant l'indice de réfraction du matériau cristallin de haut indice, ici le GaAs), et une épaisseur égale à un quart de longueur d'onde, soit λₑ/(4nₐᵣ). Elle peut être réalisée par exemple en un nitrure de silicium, par exemple du Si₃N₄ déposé par épitaxie en phase vapeur assisté par plasma (PECVD).

Lors d'une étape suivante (fig.5D), on réalise les électrodes 51p, 51d, lesquelles sont ici disposées sur la couche antireflet 26. Elles peuvent être réalisées par une opération classique de *lift-off,* par exemple par lithographie électronique d'un masque (par exemple en PMMA) déposé sur la couche antireflet 26, dépôt d'une couche d'or de 200nm d'épaisseur, puis retrait du masque par attaque chimique. On obtient ainsi les électrodes 51p, 51d formant le motif en pointe voulu.

La disposition des électrodes 51p, 51d, et notamment de l'électrode proximale 51p, vis-à-vis du fil photonique 20 définit l'axe de déformation Ad, lequel est de préférence aligné suivant l'un des axes optiques x ou y des dipôles optiques associés aux transitions excitoniques. Une étude préalable par spectroscopie optique des boîtes quantiques situées dans la zone destinée à la formation du cœur 21 avant gravure peut être effectuée pour identifier l'orientation dans le plan XY des axes optiques x et y. Ces axes optiques x et y peuvent généralement être alignés sur les axes propres cristallographiques de l'émetteur 24 dans le plan XY, mais ils peuvent présenter un désalignement. Aussi, cette identification par spectroscopie de l'orientation des axes optiques x et y permet ensuite d'orienter l'axe de déformation Ad suivant l'un des axes optiques x, y, et ainsi de rendre plus efficace la modification de la séparation en énergie S par le dispositif de correction 50 en générant des déformations ε_{XX} et ε_{YY} effectivement alignées sur les axes optiques x et y.

Ensuite, on réalise un masque de gravure 67 destiné à la formation du cœur 21 du fil photonique 20 et des piliers 53, de manière à recouvrir les électrodes 51 ainsi qu'une partie de la couche antireflet 26. Le masque de gravure 67 est ici réalisé en nickel Ni par lithographie et *lift-off.* Il comporte ainsi une partie centrale 67a destinée à la formation du cœur 21 du fil photonique 20, dont les dimensions dans le plan XY définissent celle de l'extrémité supérieure du cœur 21 du fil photonique 20, reposant ici au contact de la couche antireflet 26. Il comporte également plusieurs parties latérales 67b destinées à la formation des piliers 53, reposant ici au contact des électrodes 51.

La partie centrale 67a du masque de gravure 67 peut présenter une forme permettant d'obtenir un cœur 21 ayant la forme de section droite souhaitée, i.e. à symétrie de rotation d'ordre 4 autour de l'axe principal Δ, par ex. carrée, octogonale ou circulaire. Elle est ici circulaire et présente un diamètre d_{pc} qui dépend de l'angle de gravure α qui correspond à l'angle d'inclinaison formé par l'orientation de la bordure latérale du cœur 21 du fil photonique 20 par rapport à l'axe Z, et par la hauteur h souhaitée du fil photonique 20. Etant donné que l'on souhaite que le diamètre local du cœur 21 du fil photonique 20 dans le plan de la boîte quantique 24 soit sensiblement égal à d_{bq}=λₑ/n à une hauteur de l'ordre de 100nm au-dessus du substrat 10, le diamètre de la partie centrale est sensiblement égale à d_{bq} + 2×h×tan(α). On suppose ici que la hauteur de 100nm de la boîte quantique 24 vis-à-vis du substrat 10 est négligeable vis-à-vis de la hauteur totale h du fil photonique 20.

Les dimensions dans le plan XY des parties latérales 67b du masque de gravure 67 sont choisies en fonction de l'angle de gravure α et de la largeur souhaitée des piliers 53 au niveau de l'extrémité inférieure des piliers 53 au contact avec le substrat 10. À titre d'exemple, pour un pilier 53 dont la largeur au contact avec le substrat 10 est égale à 1µm environ, et pour une hauteur de 12µm environ, la dimension latérale des parties latérales 67b est sensiblement égale à 2.25µm environ.

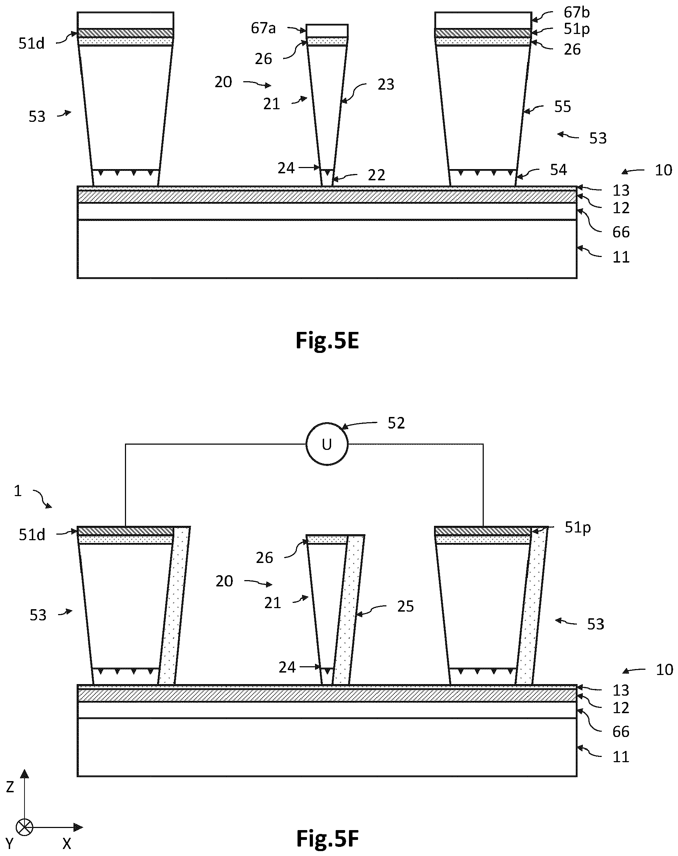

Lors d'une étape suivante (fig.5E), on effectue une gravure localisée de la couche antireflet 26, de manière à supprimer les parties non revêtues par le masque de gravure 67. La gravure peut être effectuée par exemple par gravure ionique réactive (RIE, pour *Reactive Ion Etching,* en anglais), et de préférence de sorte que les flancs gravés de la couche antireflet 26 soient sensiblement orientés suivant l'axe Z. Ainsi, la couche 64 en GaAs présente une face supérieure avec une surface libre, c'est-à-dire non revêtue par la couche antireflet 26 et par le masque de gravure 67.

Ensuite, on réalise le cœur 21 du fil photonique 20, ainsi que les piliers 53, ici par une gravure localisée de l'empilement. La gravure peut être effectuée par gravure ionique réactive (RIE) dont les caractéristiques en termes de gravure physique et gravure chimique sont définies de manière à obtenir l'angle de gravure α voulu, par exemple 3° environ. La couche diélectrique 13 forme une couche d'arrêt de gravure. Aussi, l'agent de gravure grave dans le plan XY une partie des couches en GaAs. On obtient ainsi le cœur 21 du fil photonique 20 qui contient une ou plusieurs boîtes quantiques 24 à une hauteur de 100nm environ pour laquelle le diamètre local est sensiblement égal à 200nm environ. Le fil photonique 20 s'étend continûment suivant l'axe Z entre la couche antireflet 26 et le substrat 10. On obtient également les piliers 53 qui présentent des dimensions transversales voulues au niveau du contact avec le substrat 10. La couche antireflet 26 recouvre continûment la face supérieure du cœur 21 du fil photonique 20 et des piliers 53. À la suite de cette étape, le masque de gravure 67 est supprimé, par exemple à l'aide d'une solution acide.

Lors d'une étape suivante (fig.5F), on réalise le contact électrique entre la source de tension électrique 52 et les électrodes 51 par exemple par soudage de fils en un matériau électriquement conducteur, par exemple en or ou en carbone. On réalise ensuite la gaine 25 à asymétrie axiale, ici par dépôt EBPVD d'un matériau diélectrique de bas indice de réfraction de manière directionnelle et sous incidence contrôlée. La méthode GLAD (pour *Glancing Incidence Deposition,* en anglais) décrite notamment dans l'article de Robbie & Brett intitulé Sculptured thin films and glancing angle deposition : Growth mechanics and applications, J. Vac. Sci. Technol. A 15, 1460 (1997) peut être utilisée. Le matériau diélectrique peut être choisi parmi un oxyde de silicium (par ex. SiO₂), un nitrure de silicium (par ex. Si₃N₄) et un oxyde d'aluminium (par ex. Al₂O₃), et une épaisseur de plusieurs centaines de nanomètres, par exemple 250nm, peut être déposée. Le contact électrique est de préférence réalisé avant le dépôt de la gaine 25, mais l'inverse reste possible.

Dans cet exemple, le fil photonique 20 peut comporter plusieurs boîtes quantiques 24 situés dans un même plan XY. En effet, la section droite où se trouvent les boîtes quantiques présente une surface de l'ordre de 0.04µm² et la densité de boîtes quantiques est de l'ordre de 200/µm². Il en résulte qu'il y a en moyenne environ 8 boîtes quantiques dans le cœur 21 du fil photonique 20, distribuées spatialement de manière aléatoire dans une même section droite. Ces boîtes quantiques peuvent ainsi être disposées à différentes distances de l'axe longitudinal Δ, et émettent des photons à des longueurs d'onde différentes d'une boîte quantique 24 à l'autre, du fait de la variabilité de la taille des boîtes quantiques obtenues par épitaxie. Dans ce cas, comme décrit précédemment, le dispositif de collection de la source de lumière 1 comporte avantageusement un filtre spectral (cf. fig.4A) de manière à isoler les photons émis par une boîte quantique 24 choisie, de préférence la plus proche de l'axe longitudinal Δ dans la mesure où elle présente le plus fort taux d'émission spontanée parmi les boîtes quantiques présentes et assure une durée de vie sensiblement égale des états excitoniques Xₓ et X_{y}.

On obtient ainsi une source de lumière 1 adaptée à émettre des paires de photons intriqués en polarisation, comportant un fil photonique 20 formé d'un cœur 21 monomode supportant un mode optique dégénéré en polarisation revêtu au moins partiellement par une gaine 25 à asymétrie axiale. Le dispositif de correction 50 est adapté à générer une force électrostatique générant des contraintes mécaniques dans l'émetteur 24 dont les valeurs assurent une réduction de la séparation en énergie S jusqu'à une valeur permettant la génération de paires de photons intriqués, et l'optimisation du degré d'intrication.

La figure 6 est une vue schématique et partielle, en coupe, d'une source de lumière 1 selon un autre mode de réalisation, qui se distingue de celle illustrée sur les fig.2A et 2B essentiellement en ce que le fil photonique 20 comporte un cœur 21 de forme longitudinale effilée. Par ailleurs, la source de lumière 1 ne comporte pas de couche antireflet 26.

Le cœur 21 du fil photonique 20 forme un guide d'onde monomode pour la paire de photons émis par l'émetteur 24, et comporte un adaptateur de mode optimisant l'extraction lumineuse et permettant d'obtenir un diagramme d'émission de forme gaussienne et à faible ouverture numérique. Dans cet exemple, le fil photonique 20 est réalisé à base de InP et comporte au moins une boîte quantique semiconductrice 24 en InAsP.

Le cœur 21 du fil photonique 20 présente ici un diamètre local dans la section droite contenant la boîte quantique 24 proche de λₑ/n, par exemple ici 200nm environ. L'émetteur 24 est situé à une distance ici égale à 100nm environ du substrat 10. Dans cet exemple, il présente un diamètre local sensiblement constant suivant l'axe principal Δ sur une hauteur déterminée, à partir de laquelle le diamètre local diminue suivant la direction +Z.

La source de lumière 1 selon ce mode de réalisation présente les mêmes avantages que ceux décrits précédemment, qui ne sont pas détaillés ici à nouveau. Le procédé de fabrication comprend des étapes similaires à celles décrites dans l'article de Claudon et al. intitulé Harnessing Light with Photonic Nanowires : Fundamentals and Applications to Quantum Optics, ChemPhysChem 14, 2393-2402 (2013), et à celles décrites en référence aux fig.5A à 5F.

Ainsi, la figure 7 illustre de manière schématique et partielle un fil photonique 20 d'une source de lumière 1 selon une variante de réalisation. Ici, la gaine 25 n'est pas réalisée par dépôt PVD directionnel et sous incidence rasante, mais par lithographie et gravure d'une couche d'encapsulation.

À la suite de l'étape 5E décrite précédemment, on dépose une couche d'encapsulation sur le substrat 10 de manière à entourer entièrement dans le plan XY le cœur 21 du fil photonique 20 (et donc les piliers 53 également). La couche d'encapsulation est réalisée en un matériau de faible indice de réfraction et de préférence diélectrique. Il peut ainsi s'agir d'une résine tel que le poly(méthacrylate de méthyle) (PMMA). La gaine asymétrique 25 est obtenue par lithographie électronique puis gravure de la couche d'encapsulation. Ainsi, à la différence de la gaine 25 déposée par PVD directionnel, ici la gaine 25 présente une forme suivant l'axe Z qui ne suit pas la forme effilée ou évasée du cœur 21 du fil photonique 20. Le fil photonique 20 (cœur 21 et gaine 25) présente alors une section droite de dimensions dans le plan XY sensiblement constantes le long de l'axe Z.

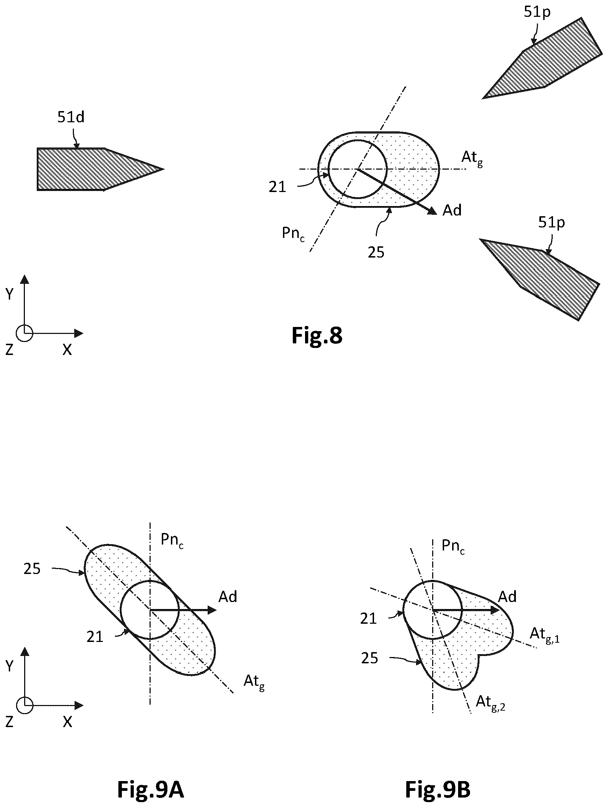

La figure 8 est une vue de dessus, schématique et partielle, d'une source de lumière 1 selon une autre variante de réalisation, dans laquelle la source de lumière 1 se distingue de celles décrites précédemment essentiellement en ce qu'elle comporte plus de deux électrodes 51, ici trois, bien qu'elle puisse comporte davantage d'électrodes 51 (notamment davantage d'électrodes proximales 51p).

Ici, le dispositif de correction 50 comporte une électrode distale 51d et deux électrodes proximales 51p. Les électrodes proximales 51p sont situées de manière symétrique l'une de l'autre vis-à-vis d'un plan passant par l'axe principal Δ et par la pointe de l'électrode distale 51d. Les deux électrodes proximales 51p sont de préférence espacées de l'axe principal Δ d'une distance identique.

Lorsqu'on utilise deux électrodes seulement, il est possible après fabrication que les dipôles optiques associés aux transitions excitoniques Xₓ et X_{y} ne soient pas exactement alignés par rapport à l'axe X suivant lequel sont alignées les deux électrodes 51 (et donc pas alignés avec l'axe de déformation Ad). Ici, en jouant sur la polarisation des deux électrodes proximales 51p, il devient possible de définir l'orientation de l'axe de déformation Ad dans le plan XY, celui-ci restant différent dans le plan XY de l'axe transversal principal At_{g} de la gaine 25, et de l'orienter suivant l'un ou l'autre des axes optiques x et y. L'efficacité de modification de la séparation en énergie S par le dispositif de correction 50 est donc améliorée.

Les figures 9A et 9B sont des vues de dessus, schématiques et partielles, de deux fils photoniques selon des variantes de réalisation, qui diffèrent entre eux par la forme de la gaine 25 à asymétrie de révolution.

Dans l'exemple de la fig.9A, la gaine 25 s'étend suivant l'axe transversal principal At_{g} de part et d'autre du cœur 21. Ici, elle présente une longueur sensiblement identique suivant les deux directions de l'axe transversal principal At_{g}. L'axe de déformation Ad forme un angle d'inclinaison compris ici entre 20° et 70° avec l'axe transversal principal At_{g}.

Dans l'exemple de la fig.9B, la gaine 25 s'étend suivant deux axes transversaux privilégiés At_{g,1} et At_{g,2}. Ces axes At_{g,1} et At_{g,2} sont définis par le fait que la gaine 25 présente une première longueur maximale suivant un axe At_{g,1} et une deuxième longueur suivant un axe At_{g,2} non colinéaire à At_{g,1}. Quoi qu'il en soit, au moins l'un des axes At_{g,1} et At_{g,2} et ici les deux axes At_{g,1} et At_{g,2} forment un angle d'inclinaison compris ici entre 20° et 70° avec l'axe de déformation Ad.

Des modes de réalisation particuliers viennent d'être décrits. Différentes variantes et modifications apparaîtront à l'homme du métier.

Dans une variante (non représentée), il est possible d'appliquer un potentiel électrique au fil photonique 20. Pour cela, le cœur 21 comporte une extrémité supérieure comportant une couche barrière en un matériau électriquement isolant, par exemple ici en Ga_{0.2}Al_{0.8}As, revêtue par une couche de GaAs dopé. Cette couche dopée est alors connectée à une électrode de contrôle par un fil électrique. Une différence de potentiel est alors appliquée au cœur 21 du fil photonique 20 entre son sommet et sa base. Le champ électrique vertical en résultant entraîne un décalage par effet Stark des niveaux d'énergie des états excitoniques Xₓ et X_{y}. Il est alors possible d'assurer simultanément la réduction et l'annulation de la séparation en énergie S, et d'ajuster la fréquence du premier photon émis dans la cascade radiative, la fréquence du deuxième photon émis (le niveau d'énergie de Xₓ étant alors égal à celui de X_{y}), voire la différence d'énergie entre les deux photons émis.

Par ailleurs, des électrodes de chauffage peuvent être disposées sur le substrat 10, à proximité du fil photonique 20. Le courant électrique entre ces électrodes provoque un échauffement au voisinage du pied du fil photonique 20, permettant de modifier les énergies des photons émis, sans modifier la séparation en énergie S. En complément de la variante ci-dessus, il est alors possible d'assurer simultanément la réduction et l'annulation de la séparation en énergie S, et d'ajuster la fréquence des photons émis, en ajustant la température d'échauffement et l'intensité du champ électrique vertical.

Dans une variante (non représentée), la source de lumière 1 peut comporter un dispositif d'excitation par injection électrique. Pour cela, le cœur 21 comporte une extrémité supérieure formée d'une couche de GaAs fortement dopé de type n, sans la couche barrière en un matériau électriquement isolant, par exemple en Ga_{0.2}Al_{0.8}As, mentionnée précédemment. La couche diélectrique est remplacée par une couche conductrice transparente, par exemple une couche d'ITO. Le cœur 21 du fil photonique 20 comporte une zone dopée de type n, par exemple entre 10¹⁶ et 10¹⁷ cm⁻³, s'étendant suivant l'axe Z depuis la couche de GaAs dopée n+ jusqu'à une hauteur située à quelques dizaines de nanomètres au-dessus de la boîte quantique 24, par exemple 50nm. Il comporte une zone dopée de type p s'étendant suivant l'axe Z depuis une hauteur située à quelques dizaines de nanomètres en-dessous de la boîte quantique 24, par exemple 50nm, jusqu'à la base du cœur 21. L'injection électrique permet alors d'injecter électriquement des paires électron-trou dans la boîte quantique 24.

## Revendications

1. Source de lumière (1) adaptée à émettre une paire de photons intriqués en polarisation, comportant :
o un substrat (10), comportant une couche réflectrice (12) ;
o un fil photonique (20), comportant un cœur (21) présentant un indice de réfraction n_{c} et étant :
• disposé sur le substrat (10) en regard de la couche réflectrice (12), et s'étendant longitudinalement suivant un axe principal Δ sensiblement orthogonal au plan du substrat (10) ;
• comportant un émetteur (24), adapté à émettre une paire de photons destinés à être intriqués en polarisation ;
• présentant des dimensions transversales, dans un plan parallèle au substrat et contenant l'émetteur (24), telles que le cœur (21) forme un guide d'onde monomode pour les photons émis, le mode optique guidé étant dégénéré en polarisation,
• ces dimensions transversales variant longitudinalement en direction d'une extrémité supérieure (21.2) du cœur (21), de manière à former un adaptateur de mode pour le mode optique guidé ;
o un dispositif d'excitation optique (30), adapté à exciter l'émetteur (24) et ainsi à provoquer une émission spontanée par l'émetteur (24) d'au moins une paire de photons ; source de lumière (1) dans laquelle le fil photonique (20) comporte en outre une gaine (25) :
• présentant un indice de réfraction n_{g} inférieur à n_{c} ;
• s'étendant dans un plan parallèle au substrat (10) à partir du cœur (21), et présentant une dimension maximale par rapport à l'axe principal Δ définissant un axe transversal principal At_{g} de sorte qu'elle présente une asymétrie de révolution autour de l'axe principal Δ ;
la source de lumière (1) comportant en outre:
o un dispositif de correction (50), adapté à induire par effet électrostatique une déformation mécanique du fil photonique (20) dans un plan parallèle au substrat (10), suivant un axe de déformation Ad formant un angle d'inclinaison compris entre 0° et 90°, ces valeurs étant exclues, vis-à-vis de l'axe transversal principal At_{g}, la déformation mécanique se traduisant par des contraintes mécaniques subies par l'émetteur (24), améliorant ainsi le degré d'intrication de la paire de photons.

2. Source de lumière (1) selon la revendication 1, dans laquelle le dispositif de correction (50) comporte :
o au moins deux électrodes (51),
• adaptées à générer un champ électrique non uniforme,
• agencées de part et d'autre du fil photonique (20) de sorte que le fil photonique (20) présente une distance Dₚ à l'une des électrodes dite proximale (51p) inférieure à une distance D_{d} à l'autre électrode dite distale (51p), l'axe de déformation Ad étant défini comme passant par une extrémité de l'électrode proximale (51p) orientée vers le fil photonique (20) et l'axe principal Δ ;
o une source de tension électrique (52), connectée aux électrodes (51), pour générer ledit champ électrique, la valeur de la tension étant prédéfinie de sorte que la paire de photons est intriquée en polarisation.

3. Source de lumière (1) selon la revendication 2, dans laquelle le dispositif de correction (50) comporte des piliers (53) reposant sur le substrat (10) et distincts du fil photonique (20), sur lesquels reposent les électrodes (51) ; le cœur (21) du fil photonique (20) et les piliers (53) étant réalisés à base d'un même matériau cristallin.

4. Source de lumière (1) selon la revendication 3, dans laquelle le cœur (21) du fil photonique (20) et les piliers (53) présentent une même hauteur vis-à-vis du substrat (10).

5. Source de lumière (1) selon l'une quelconque des revendications 1 à 4, dans laquelle l'émetteur (24) présente un état biexcitonique XX, deux états excitoniques Xₓ, X_{y} et un état fondamental G, deux dipôles optiques étant associés aux transitions excitoniques entre l'état biexcitonique XX et les états excitoniques Xₓ, X_{y}, et entre les états excitoniques Xₓ, X_{y}, et l'état fondamental G, les dipôles optiques présentant des polarisations linéaires orientées suivant des axes optiques x, y orthogonaux entre eux et étant situés dans un plan parallèle au substrat (10), l'axe de déformation Ad étant aligné sur l'un des axes optiques x, y.

6. Source de lumière (1) selon l'une quelconque des revendications 1 à 5, dans laquelle l'émetteur (24) est situé sur l'axe principal Δ, à 20nm près.

7. Source de lumière (1) selon l'une quelconque des revendications 1 à 6, dans laquelle le cœur (21) du fil photonique (20) présente une symétrie de rotation autour de l'axe principal Δ d'ordre égal à 4.

8. Source de lumière (1) selon l'une quelconque des revendications 1 à 7, dans laquelle le cœur (21) du fil photonique (20) est réalisé à base d'un matériau cristallin choisi parmi les composés III-V ou les composés II-VI, et dans laquelle l'émetteur (24) est formé d'au moins une boîte quantique semiconductrice.

9. Procédé de fabrication d'une source de lumière (1) selon l'une quelconque des revendications précédentes, dans lequel :
∘ on réalise un empilement comportant :
• un substrat (10), comportant une couche réflectrice (12) revêtue d'une couche transparente (13) d'arrêt de gravure ;
• une première et une deuxième couche (64, 65), reposant sur la couche transparente (13), réalisées en un matériau cristallin d'indice de réfraction n_{c}, entre lesquelles est situé l'émetteur (24) ;
∘ on réalise le cœur (21) du fil photonique (20) par gravure localisée de l'empilement ;
∘ on réalise la gaine (25) de sorte qu'elle s'étende à partir du cœur (21) suivant un axe transversal principal At_{g} dans un plan parallèle au plan du substrat.

10. Procédé de fabrication selon la revendication 9, dans lequel la gaine (25) est réalisée par dépôt physique en phase vapeur suivant une direction de dépôt parallèle à l'axe transversal principal At_{g} souhaité et formant un angle d'inclinaison vis-à-vis du plan du substrat (10) inférieur à 90°, et de préférence inférieur ou égal à 20°.

11. Procédé de fabrication selon la revendication 9, dans lequel la gaine (25) est réalisée par dépôt d'une couche diélectrique d'encapsulation entourant le cœur (21) du fil photonique (20) dans un plan parallèle au substrat (10) sur toute la hauteur du cœur (21), lithographie puis gravure localisée de la couche diélectrique d'encapsulation.

12. Procédé de fabrication selon l'une quelconque des revendications 9 à 11, dans lequel, lors de la réalisation du cœur (21) du fil photonique (20), des piliers (53) sont réalisés simultanément par gravure localisée de l'empilement, et dans lequel on réalise au moins deux électrodes (51) sur des faces supérieures des piliers (53), lesdites électrodes (51) étant disposées de part et d'autre du cœur (21) du fil photonique (20).

## Patentansprüche

1. Lichtquelle (1) zur Aussendung eines Paars polarisations-verschränkter Photonen, aufweisend:
o ein Substrat (10) mit einer reflektierenden Schicht (12);
o einen photonischen Draht (20), der einen Kern (21) mit einem Brechungsindex n_{c} aufweist und:
• auf dem Substrat (10) gegenüber der reflektierenden Schicht (12) angeordnet ist und sich in Längsrichtung entlang einer Hauptachse Δ im Wesentlichen orthogonal zur Ebene des Substrats (10) erstreckt;
• einen Emitter (24) aufweist, der geeignet ist, ein Paar Photonen auszusenden, die dazu bestimmt sind, polarisations-verschränkt zu sein;
• Querabmessungen in einer Ebene aufweist, die parallel zum Substrat verläuft und den Emitter (24) enthält, so dass der Kern (21) einen Einmodenwellenleiter für die ausgesendeten Photonen bildet, wobei die geführte optische Mode polarisationsdegeneriert ist,
• wobei diese Querabmessungen längs in Richtung eines oberen Endes (21.2) des Kerns (21) variieren, so dass ein Modenadapter für die geführte optische Mode gebildet wird;
o eine Vorrichtung zur optischen Anregung (30), die geeignet ist, den Emitter (24) anzuregen und so eine spontane Aussendung wenigstens eines Paars Photonen durch den Emitter (24) zu bewirken;
bei welcher Lichtquelle (1) der photonische Draht (20) ferner eine Ummantelung (25) aufweist:
• die einen Brechungsindex n_{g} kleiner als n_{c} aufweist;
• die sich in einer Ebene parallel zum Substrat (10) ausgehend von dem Kern (21) erstreckt und eine maximale Abmessung im Verhältnis zur Hauptachse Δ aufweist, die eine Hauptquerachse At_{g} definiert, so dass sie eine Rotationsasymmetrie um die Hauptachse Δ aufweist;
wobei die Lichtquelle (1) ferner Folgendes aufweist:
o eine Korrekturvorrichtung (50), die geeignet ist, durch elektrostatische Wirkung eine mechanische Verformung des photonischen Drahts (20) in einer Ebene parallel zum Substrat (10) entlang einer Verformungsachse Ad herbeizuführen, die einen Neigungswinkel zwischen 0° und 90°, ausschließlich dieser Werte, zur Hauptquerachse At_{g} bildet, wobei sich die mechanische Verformung durch mechanische Spannungen äußert, die der Emitter (24) erfährt, wobei so der Verschränkungsgrad des Photonenpaars verbessert wird.

2. Lichtquelle (1) nach Anspruch 1, wobei die Korrekturvorrichtung (50) Folgendes aufweist:
o wenigstens zwei Elektroden (51),
• die geeignet sind, ein ungleichmäßiges elektrisches Feld zu erzeugen,
• die beiderseits des photonischen Drahts (20) so angeordnet sind, dass der photonische Draht (20) einen Abstand Dₚ zu einer der Elektroden, die proximal (51p) genannt wird, und einen Abstand D_{d} zur anderen Elektrode, die distal (51p) genannt wird, aufweist, wobei die Verformungsachse Ad als durch ein Ende der proximalen Elektrode (51p) hindurchgehend definiert ist, die in Richtung des photonischen Drahts (20) und der Hauptachse Δ orientiert ist;
o eine elektrische Spannungsquelle (52), die an die Elektroden (51) angeschlossen ist, um das elektrische Feld zu erzeugen, wobei der Wert der Spannung so vorgegeben ist, dass das Photonenpaar polarisations-verschränkt ist.

3. Lichtquelle (1) nach Anspruch 2, wobei die Korrekturvorrichtung (50) Pfeiler (53) aufweist, die auf dem Substrat (10) aufliegen und vom photonischen Draht (20) verschieden sind, auf denen die Elektroden (51) aufliegen; wobei der Kern (21) des photonischen Drahts (20) und die Pfeiler (53) aus einem gleichen kristallinen Material hergestellt sind.

4. Lichtquelle (1) nach Anspruch 3, wobei der Kern (21) des photonischen Drahts (20) und die Pfeiler (53) ein und dieselbe Höhe gegenüber dem Substrat (10) aufweisen.

5. Lichtquelle (1) nach einem der Ansprüche 1 bis 4, wobei der Emitter (24) einen biexcitonischen Zustand XX, zwei excitonische Zustände Xₓ, X_{y} und einen Grundzustand G aufweist, wobei zwei optische Dipole den excitonischen Übergängen zwischen dem biexcitonischen Zustand XX und den excitonischen Zuständen Xₓ, X_{y} und zwischen den excitonischen Zuständen Xₓ, X_{y} und dem Grundzustand G zugeordnet sind, wobei die optischen Dipole lineare Polarisationen aufweisen, die entlang optischen Achsen x, y orientiert sind, die orthogonal zueinander verlaufen und sich in einer Ebene parallel zum Substrat (10) befinden, wobei die Verformungsachse Ad an einer der optischen Achsen x, y ausgerichtet ist.

6. Lichtquelle (1) nach einem der Ansprüche 1 bis 5, wobei sich der Emitter (24) auf 20 nm genau auf der Hauptachse Δ befindet.

7. Lichtquelle (1) nach einem der Ansprüche 1 bis 6, wobei der Kern (21) des photonischen Drahts (20) eine 4-zählige Rotationssymmetrie um die Hauptachse Δ aufweist.

8. Lichtquelle (1) nach einem der Ansprüche 1 bis 7, wobei der Kern (21) des photonischen Drahts (20) aus einem kristallinen Material hergestellt ist, das aus den Verbindungen III-V oder den Verbindungen II-VI gewählt ist, und wobei der Emitter (24) von wenigstens einem Halbleiter-Quantenpunkt gebildet ist.

9. Verfahren zur Herstellung einer Lichtquelle (1) nach einem der vorhergehenden Ansprüche, wobei:
o ein Stapel hergestellt wird, der Folgendes aufweist:
• ein Substrat (10) mit einer reflektierenden Schicht (12), die von einer transparenten Ätzsperrschicht (13) bedeckt ist;
• eine erste und eine zweite Schicht (64, 65), die auf der transparenten Schicht (13) aufliegen, die aus einem kristallinen Material mit einem Brechungsindex n_{c} hergestellt sind, zwischen denen sich der Emitter (24) befindet;
o der Kern (21) des photonischen Drahts (20) durch lokalisierte Ätzung des Stapels hergestellt wird;
o die Ummantelung (25) so hergestellt wird, dass sie sich ausgehend von dem Kern (21) entlang einer Hauptquerachse At_{g} in einer Ebene parallel zur Ebene des Substrats erstreckt.

10. Herstellungsverfahren nach Anspruch 9, wobei die Ummantelung (25) durch physikalische Gasphasenabscheidung in einer Abscheidungsrichtung parallel zur gewünschten Hauptquerachse At_{g} und mit einem Neigungswinkel zur Ebene des Substrats (10) kleiner als 90° und vorzugsweise kleiner als oder gleich 20° hergestellt wird.

11. Herstellungsverfahren nach Anspruch 9, wobei die Ummantelung (25) durch Abscheidung einer dielektrischen Kapselungsschicht, die den Kern (21) des photonischen Drahts (20) in einer Ebene parallel zum Substrat (10) über die gesamte Höhe des Kerns (21) umgibt, Lithographie dann lokalisierte Ätzung der dielektrischen Kapselungsschicht hergestellt wird.

12. Herstellungsverfahren nach einem der Ansprüche 9 bis 11, wobei bei der Herstellung des Kerns (21) des photonischen Drahts (20) Pfeiler (53) gleichzeitig durch lokalisierte Ätzung des Stapels hergestellt werden, und wobei wenigstens zwei Elektroden (51) auf Oberseiten der Pfeiler (53) hergestellt werden, wobei die Elektroden (51) beiderseits des Kerns (21) des photonischen Drahts (20) angeordnet sind.

## Claims

1. Light source (1) configured to emit a pair of polarization-entangled photons, comprising:
o a substrate (10) comprising a reflective layer (12);
o a photonic wire (20) comprising a core (21) having a refractive index n_{c} and:
• being arranged on the substrate (10), facing the reflective layer (12), and extending longitudinally along a principal axis Δ substantially orthogonal to the plane of the substrate (10);
• comprising an emitter (24) configured to emit a pair of photons which are intended to be entangled in polarization;
• having transverse dimensions, in a plane parallel to the substrate and containing the emitter (24), such that the core (21) forms a single-mode waveguide for the emitted photons, the guided optical mode being degenerate in polarization;
• these transverse dimensions varying longitudinally in the direction of an upper end (21.2) of the core (21) so as to form a mode adapter for the guided optical mode;
o an optical excitation device (30) configured to excite the emitter (24) and thus cause spontaneous emission of at least one pair of photons by the emitter (24);
in which light source (1) the photonic wire (20) furthermore comprising a cladding (25):
• having a refractive index n_{g} less than n_{c;}
• extending in a plane parallel to the substrate (10), starting from the core (21), and having a maximum dimension with respect to the principal axis Δ defining a principal transverse axis At_{g} such that it has an asymmetry of revolution about the principal axis Δ;
the light source (1) further comprising:
o a correction device (50) configured to induce by electrostatic effect a mechanical deformation of the photonic wire (20) in a plane parallel to the substrate (10), along a deformation axis Ad forming an angle of inclination of between 0° and 90°, these values being exclusive, with respect to the principal transverse axis At_{g}, the mechanical deformation leading to mechanical strains experienced by the emitter (24), thus improving the degree of entanglement of the photon pair.

2. Light source (1) according to Claim 1, wherein the correction device (50) comprises:
o at least two electrodes (51),
• configured to generate a nonuniform electric field,
• arranged on either side of the photonic wire (20) in such a way that the photonic wire (20) has a distance Dₚ from the proximal one (51p) of the electrodes less than a distance D_{d} from the other, distal electrode (51p), the deformation axis Ad being defined as passing through a proximal electrode (51p) end oriented toward the photonic wire (20) and the principal axis Δ;
o an electrical voltage source (52) connected to the electrodes (51) in order to generate said electric field, the value of the voltage being predefined in such a way that the photon pair is entangled in polarization.

3. Light source (1) according to Claim 2, wherein the correction device (50) comprises pillars (53) which rest on the substrate (10) and are separate from the photonic wire (20), and on which the electrodes (51) rest; the core (21) of the photonic wire (20) and the pillars (53) being produced on the basis of the same crystalline material.

4. Light source (1) according to Claim 3, wherein the core (21) of the photonic wire (20) and the pillars (53) have the same height with respect to the substrate (10).

5. Light source (1) according to any one of Claims 1 to 4, wherein the emitter (24) has a biexcitonic state XX, two excitonic states Xₓ, X_{y} and a ground state G, two optical dipoles being associated with the excitonic transitions between the biexcitonic state XX and the excitonic states Xₓ, X_{y} and between the excitonic states Xₓ, X_{y}, and the ground state G, the optical dipoles having linear polarizations oriented along mutually orthogonal optical axes x, y and being located in a plane parallel to the substrate (10), the deformation axis Ad being aligned with one of the optical axes x, y.

6. Light source (1) according to any one of Claims 1 to 5, wherein the emitter (24) is located on the principal axis Δ, to within 20 nm.

7. Light source (1) according to any one of Claims 1 to 6, wherein the core (21) of the photonic wire (20) has a symmetry of rotation about the principal axis Δ with an order equal to 4.

8. Light source (1) according to any one of Claims 1 to 7, wherein the core (21) of the photonic wire (20) is produced on the basis of a crystalline material selected from among III-V compounds or II-VI compounds, and wherein the emitter (24) is formed by at least one semiconductor quantum dot.

9. Method for manufacturing a light source (1) according to any one of the preceding claims, wherein:
o a stack comprising the following is produced:
• a substrate (10) comprising a reflective layer (12) coated with a transparent etch stop layer (13);
• a first and a second layer (64, 65) resting on the transparent layer (13) and produced from a crystalline material with a refractive index n_{c}, between which the emitter (24) is located;
o the core (21) of the photonic wire (20) is produced by localized etching of the stack;
o the cladding (25) is produced in such a way that it extends from the core (21) along a principal transverse axis At_{g} in a plane parallel to the plane of the substrate.

10. Manufacturing method according to Claim 9, wherein the cladding (25) is produced by physical vapour deposition along a deposition direction parallel to the desired principal transverse axis At_{g} and forming an angle of inclination with respect to the plane of the substrate (10) of less than 90°, and preferably less than or equal to 20°.

11. Manufacturing method according to Claim 9, wherein the cladding (25) is produced by deposition of a dielectric encapsulation layer enclosing the core (21) of the photonic wire (20) in a plane parallel to the substrate (10) over the entire height of the core (21), lithography then localized etching of the dielectric encapsulation layer.

12. Manufacturing method according to any one of Claims 9 to 11, wherein pillars (53) are simultaneously produced by localized etching of the stack during the production of the core (21) of the photonic wire (20), and wherein at least two electrodes (51) are produced on upper faces of the pillars (53), said electrodes (51) being arranged on either side of the core (21) of the photonic wire (20).
